(19) Europäisches Patentamt
European Patent Office
Office européen des brevets

(11) EP 4 344 392 B1

(12) **EUROPEAN PATENT SPECIFICATION**

(45) Date of publication and mention of the grant of the patent:
**18.03.2026 Bulletin 2026/12**

(21) Application number: **23198149.9**

(22) Date of filing: **19.09.2023**

(51) International Patent Classification (IPC):
***H10K 85/60*** *(2023.01)* *H10K 50/12* *(2023.01)*
*H10K 101/30* *(2023.01)*

(52) Cooperative Patent Classification (CPC):
**H10K 85/622; H10K 85/624; H10K 85/626; H10K 85/6572; H10K 85/6574; H10K 85/6576;**
H10K 50/121; H10K 2101/30

(54) **ORGANIC LIGHT-EMITTING ELEMENT**
ORGANISCHES LICHTEMITTIERENDES ELEMENT
ÉLÉMENT ÉLECTROLUMINESCENT ORGANIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **26.09.2022 JP 2022152292**

(43) Date of publication of application:
**27.03.2024 Bulletin 2024/13**

(73) Proprietor: **CANON KABUSHIKI KAISHA**
**Tokyo 146-8501 (JP)**

(72) Inventors:
- **OHRUI, Hiroki**
**Tokyo 146-8501 (JP)**
- **NISHIDE, Yosuke**
**Tokyo 146-8501 (JP)**
- **IWAWAKI, Hironobu**
**Tokyo 146-8501 (JP)**
- **HORIUCHI, Takayuki**
**Tokyo 146-8501 (JP)**
- **MIYASHITA, Hirokazu**
**Tokyo 146-8501 (JP)**
- **YAMADA, Naoki**
**Tokyo 146-8501 (JP)**

(74) Representative: **TBK**
**Bavariaring 4-6**
**80336 München (DE)**

(56) References cited:
**WO-A1-2010/047403** **KR-A- 20140 021 969**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Processed by Luminess, 75001 PARIS (FR)

## Description

BACKGROUND OF THE INVENTION

Field of the Disclosure

The present disclosure relates to an organic light-emitting element and equipment and an apparatus including the organic light-emitting element.

Description of the Related Art

An organic light-emitting element (hereinafter sometimes referred to as an "organic electroluminescent element" or an "organic EL element") is an electronic element that includes a pair of electrodes and an organic compound layer between the electrodes. Electrons and holes are injected from the pair of electrodes to generate an exciton of a light-emitting organic compound in the organic compound layer. When the exciton returns to its ground state, the organic light-emitting element emits light.
With recent significant advances in organic light-emitting elements, it is characteristically possible to realize low drive voltage, various emission wavelengths, high-speed responsivity, and thin and light light-emitting devices.
Compounds suitable for organic light-emitting elements have been actively developed. This is because it is important to develop a compound with high durability for high-performance organic light-emitting elements. Compounds with a naphthalene ring substituted with a fused polycyclic group have been developed, and Japanese Patent Laid-Open No. 2010-123917 describes the following compound 1-A.

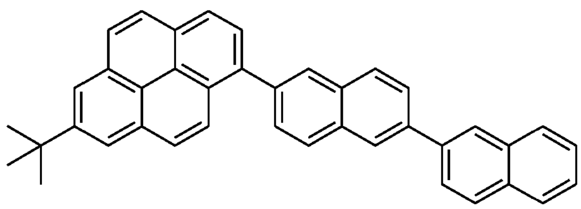

1-A

Japanese Patent Laid-Open No. 2010-123917 discloses a synthesis example of the compound 1-A and the usefulness of the compound 1-A as a host material. However, it is desired to improve durability characteristics under constant-current continuous operation conditions.
KR 2014 0021969 A discloses a compound represented by a chemical formula 1, an organic electroluminescent device including the same, and an organic solar cell including the same.

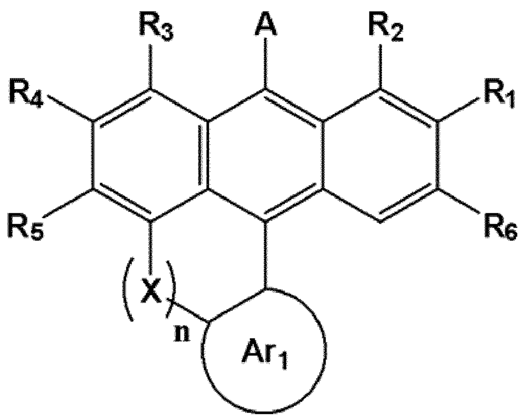

SUMMARY OF THE INVENTION

The present disclosure provides an organic light-emitting element with high operation durability.
The present disclosure in its first aspect provides an organic light-emitting element as specified in claims 1 to 10.
The present disclosure in its second aspect provides a display apparatus as specified in claim 11.

The present disclosure in its third aspect provides a photoelectric conversion apparatus as specified in claim 12.
The present disclosure in its fourth aspect provides electronic equipment as specified in claim 13.
The present disclosure in its fifth aspect provides a lighting apparatus as specified in claim 14.
The present disclosure in its sixth aspect provides a moving body as specified in claim 15.
The present disclosure in its seventh aspect provides an exposure light source as specified in claim 16.
Further features of the present disclosure will become apparent from the following description of exemplary embodiments with reference to the attached drawings.

BRIEF DESCRIPTION OF THE DRAWINGS

Fig. 1 is a view of an orbital distribution for LUMO by molecular orbital calculation of first and second compounds according to the present disclosure and comparative compounds.
Fig. 2A is a schematic cross-sectional view of an example of a pixel of a display apparatus according to an embodiment of the present disclosure.
Fig. 2B is a schematic cross-sectional view of an example of a display apparatus including an organic light-emitting element according to an embodiment of the present disclosure.
Fig. 3 is a schematic view of an example of a display apparatus according to an embodiment of the present disclosure.
Fig. 4A is a schematic view of an example of an imaging apparatus according to an embodiment of the present disclosure.
Fig. 4B is a schematic view of an example of electronic equipment according to an embodiment of the present disclosure.
Fig. 5A is a schematic view of an example of a display apparatus according to an embodiment of the present disclosure.
Fig. 5B is a schematic view of an example of a foldable display apparatus.
Fig. 6A is a schematic view of an example of a lighting apparatus according to an embodiment of the present disclosure.
Fig. 6B is a schematic view of an example of a moving body with a vehicle lamp according to an embodiment of the present disclosure.
Fig. 7A is a schematic view of an example of a wearable device according to an embodiment of the present disclosure.
Fig. 7B is a schematic view of another example of a wearable device according to an embodiment of the present disclosure.
Fig. 8A is a schematic view of an example of an image-forming apparatus according to an embodiment of the present disclosure.
Fig. 8B is a schematic view of an example of an exposure light source for an image-forming apparatus according to an embodiment of the present disclosure.
Fig. 8C is a schematic view of an example of an exposure light source for an image-forming apparatus according to an embodiment of the present disclosure.

DESCRIPTION OF THE EMBODIMENTS

The present disclosure provides a long-life organic light-emitting element. To increase the lifetime of an organic light-emitting element, it is necessary to prevent the degradation of an organic material, particularly an organic material used for a light-emitting layer, in the element. In general, to increase the lifetime of an organic light-emitting element, it is effective to expand a recombination region to prevent degradation caused by the concentration of exciton generation. The concentration of exciton generation causes energy transfer to a molecule in an excited state from a molecule in another excited state and causes transition to a higher energy state. In a high energy state, exceeding the binding energy of a single bond site in a molecular structure causes a cleavage of the bond and generates a decomposition product, thereby causing luminance decay. To avoid this, it is effective to disperse exciton generation.
Continuous energization at a high current density increases the collision probability of continuously generated excitons with cation radicals or anion radicals generated by electrons or holes. These radical species are active species for excitons and cause quenching, and it is therefore necessary to reduce the collision probability between excitons and electric charges particularly at a high current density. As a method of reducing the collision probability, in the present disclosure, it is considered to be effective to configure a light-emitting layer to contain a material that has the same partial structure as a host material, has higher electron acceptability than the host material, and is not involved in light emission, thereby controlling charge injection into the light-emitting layer and reducing the collision probability between electric charges and excitons.

In the present disclosure, an organic compound layer has a layer containing a first compound represented by the following general formula [1] and a second compound represented by the following general formula [2]. Both the first compound and the second compound are organic compounds.

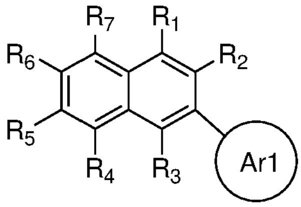

[1]

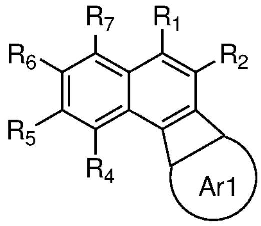

[2]

In the general formulae [1] and [2], $R_1$ to $R_7$ are each independently selected from the group consisting of a hydrogen atom, deuterium, a linear, branched, or cyclic substituted or unsubstituted alkyl group, a substituted or unsubstituted aryl group, and a substituted or unsubstituted heterocyclic group, and Ar1 denotes a substituted or unsubstituted tricyclic or higher cyclic fused group. The characteristics of the light-emitting layer are described below by taking, as an example, an embodiment of the light-emitting layer including a first compound, a second compound, and a light-emitting material.

[1] The LUMO level of the second compound is lower than the LUMO level of the first compound (in a direction away from the vacuum level) and is lower than the LUMO level of the light-emitting material (in a direction away from the vacuum level), that is, the second compound has the highest electron acceptability in the light-emitting layer. In other words, the first compound, the second compound, and the light-emitting material have LUMO energy levels $LUMO_1$, $LUMO_2$, and $LUMO_E$, respectively, satisfying the following formula [A].

$$|LUMO_2| > |LUMO_E| > |LUMO_1| \quad [A]$$

Table 1 shows, as an example of the present embodiment, an organic light-emitting element with a light-emitting layer containing a compound in which Ar1 in the general formula [1] is 1-pyrene and Ar1 in the general formula [2] is 1,10-pyrene, $R_1$ to $R_5$ and $R_7$ are hydrogen, and $R_6$ is substituted with 2-naphthalene. In Comparative Example A, the second compound is not contained. In Comparative Example B, the second compound does not correspond to the general formula [2] and is a compound with a structure in which pyrene and the 2-position and 3-position of naphthalene form a ring.

Table 1 shows the calculated values of the LUMO levels of the first compound, the second compound, and the light-emitting material, the difference ΔLUMO1 between the calculated values of the LUMO levels of the first compound and the second compound, and the difference ΔLUMO2 between the calculated values of the LUMO levels of the first compound and the light-emitting material. Furthermore, LT95 is the time when the luminance is reduced by 5% during energization at a current density of 200 mA/$cm^2$, and is a relative value based on the value of Comparative Example A.

Table 1

| | | First compound | Second compound | Light-emitting material | ΔLUMO1 | ΔLUMO2 | LT95 |
|---|---|---|---|---|---|---|---|
| Exemplary embodiment 1-1 | Molecular structure | 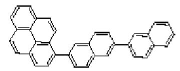 | 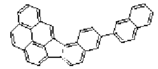 | 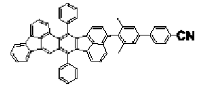 | 0.54 | 0.39 | 1.5 |
| | LUMO [eV] | -1.67 | -2.21 | -2.06 | | | |
| | Oscillator strength | 0.78 | 0.07 | 0.61 | | | |
| Comparative example A | Molecular structure | 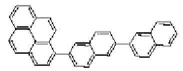 | | 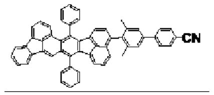 | | 0.39 | 1.0 |
| | LUMO [eV] | -1.67 | | -2.06 | | | |
| | Oscillator strength | 0.78 | | 0.61 | | | |
| Comparative example B | Molecular structure | 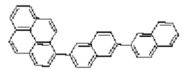 | 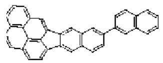 | 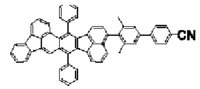 | 0.32 | 0.39 | 0.9 |
| | LUMO [eV] | -1.67 | -1.99 | -2.06 | | | |
| | Oscillator strength | 0.78 | 0.44 | 0.61 | | | |

As shown in Table 1, in Exemplary Embodiment 1-1, the presence of the second compound with a lower LUMO level than the first compound and the light-emitting material (in a direction away from the vacuum level) results in ΔLUMO2 < ΔLUMO1, and the second compound has the highest electron acceptability in the light-emitting layer and improves durability lifetime. In Comparative Example A, the light-emitting material has electron acceptability and emits light through an excitation process, thus resulting in an increased collision probability between excitons and electrons in a high current density region and causing quenching. On the other hand, in Exemplary Embodiment 1-1, introducing the second compound with a lower LUMO level than the light-emitting material (in a direction away from the vacuum level) into the light-emitting layer can avoid charge concentration to the light-emitting material and suppress exciton decomposition by reducing the collision probability between excitons and electrons.

In Comparative Example B, the second compound has a higher LUMO level than the light-emitting material (in a direction closer to the vacuum level) and does not play the role of avoiding charge concentration to the light-emitting material. Thus, the second compound has no effect of improving the lifetime and rather tends to reduce the lifetime. This is because the second compound of Comparative Example B does not satisfy the requirements necessary for the present disclosure. This is explained below.

[2] The second compound has low oscillator strength and is not involved in light emission.

As shown in Table 1, the second compound in Exemplary Embodiment 1-1 has an oscillator strength (calculated value) of 0.07. The oscillator strength is a value indicating transition probability from the ground state to an excited state. An oscillator strength of less than 0.1 indicates very low transition probability, thus resulting in no involvement in light emission. Thus, the second compound in Exemplary Embodiment 1-1 has only a function of trapping electric charges and plays the role of avoiding charge concentration due to excitons. On the other hand, the second compound used in Comparative Example B has an oscillator strength (calculated value) of 0.44, has some transition probability, and is involved in light emission. In Comparative Example B, therefore, not only the light-emitting material but also the second compound emits light, and the second compound has lower stability than the light-emitting material, so that Comparative Example B has lower LT95 than Comparative Example A, which does not contain the second compound.

Due to ΔLUMO1 < ΔLUMO2 in Comparative Example B of Table 1, the light-emitting material has the highest electron acceptability, and the second compound has a slight effect.

Table 2 shows organic light-emitting elements with the same structure as those of Exemplary Embodiment 1-1 and Comparative Examples A and B in Table 1 except that the light-emitting material is changed to a compound with reduced electron acceptability. As shown in Table 2, Comparative Example D with ΔLUMO1 > ΔLUMO2 has a more significant difference from Exemplary Embodiment 1-2 containing the second compound represented by the general formula [2].

Table 2

| | | First compound | Second compound | Light-emitting material | ΔLUMO1 | ΔLUMO2 | LT95 |
|---|---|---|---|---|---|---|---|
| Exemplary embodiment 1-2 | Molecular structure | 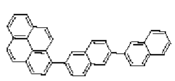 | 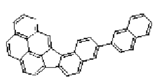 | 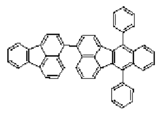 | 0.54 | 0.17 | 1.8 |
| | LUMO [eV] | -1.67 | -2.21 | -1.84 | | | |
| | Oscillator strength | 0.78 | 0.07 | 0.34 | | | |
| Comparative example C | Molecular structure | 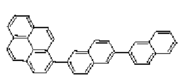 | | 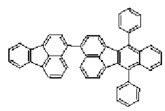 | | 0.17 | 1.0 |
| | LUMO [eV] | -1.67 | | -1.84 | | | |
| | Oscillator strength | 0.78 | | 0.34 | | | |

(continued)

| | | First compound | Second compound | Light-emitting material | ΔLUMO1 | ΔLUMO2 | LT95 |
|---|---|---|---|---|---|---|---|
| Comparative example D | Molecular structure | 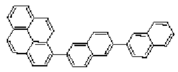 | 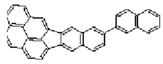 | 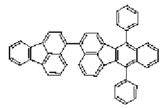 | 0.32 | 0.17 | 0.8 |
| | LUMO [eV] | -1.67 | -1.99 | -1.84 | | | |
| | Oscillator strength | 0.78 | 0.44 | 0.34 | | | |

Although not only Exemplary Embodiment 1-2 but also Comparative Example D has the relationship of ΔLUMO1 > ΔLUMO2, the difference in LT95 is larger than that in Table 1. Due to ΔLUMO1 > ΔLUMO2, in both Exemplary Embodiment 1-2 and Comparative Example D, the second compound is a compound with the highest electron acceptability, and the combination avoids charge concentration to the light-emitting material. In Comparative Example D, however, the second compound has almost the same oscillator strength as the light-emitting material and is involved in light emission by itself. In Comparative Example D, this increases exciton generation in the second compound, increases the collision probability with electrons, promotes the decomposition of excitons, and reduces the lifetime. On the other hand, the second compound in Exemplary Embodiment 1-2 has low oscillator strength, has low transition probability, and is not involved in light emission. Thus, no exciton is generated in the second compound, and excitons are generated only in the light-emitting material in the light-emitting layer. Furthermore, the second compound traps electric charges, can reduce the collision probability between excitons and electric charges, and thereby improves the lifetime.

[3] The second compound has the same partial structure as the first compound.

Table 3 shows an organic light-emitting element with the same structure as that of Exemplary Embodiment 1-2 in Table 2 except that a compound with a structure significantly different from that of the first compound was used as the second compound, together with Exemplary Embodiment 1-2 and Comparative Example C in Table 2.

Table 3

| | | First compound | Second compound | Light-emitting material | ΔLUMO1 | ΔLUMO2 | LT95 |
|---|---|---|---|---|---|---|---|
| Exemplary embodiment 1-2 | Molecular structure | 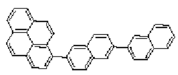 | 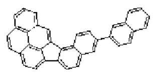 | 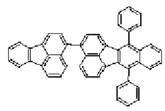 | 0.54 | 0.17 | 1.8 |
| | LUMO [eV] | -1.67 | -2.21 | -1.84 | | | |
| | Oscillator strength | 0.78 | 0.07 | 0.34 | | | |
| Comparative example C | Molecular structure | 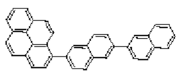 | | 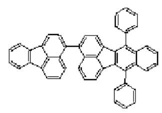 | | 0.17 | 1.0 |
| | LUMO [eV] | -1.67 | | -1.84 | | | |
| | Oscillator strength | 0.78 | | 0.34 | | | |

(continued)

| | | First compound | Second compound | Light-emitting material | ΔLUMO1 | ΔLUMO2 | LT95 |
|---|---|---|---|---|---|---|---|
| Comparative example E | Molecular structure | 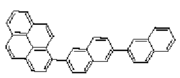 | 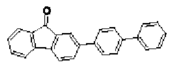 | 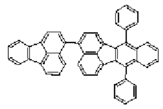 | 0.59 | 0.17 | 0.6 |
| | LUMO [eV] | -1.67 | -2.26 | -1.84 | | | |
| | Oscillator strength | 0.78 | 0.07 | 0.34 | | | |

The first compound and the second compound according to the present disclosure are compounds that mainly play the role of charge transfer in the light-emitting layer. As shown in Table 3, even if ΔLUMO1 > 0, the effect of improving the lifetime cannot be obtained when the first compound and the second compound have greatly different structures, as shown in Comparative Example E. In the present embodiment, the first compound can be used as a host, and the second compound can be used as an assist. As shown in Exemplary Embodiment 1-2, when these two materials have a common partial structure, electric charges are not excessively accumulated in the light-emitting layer. Furthermore, due to ΔLUMO1 > 0, electron trapping to the second compound and hopping while a trapped electron is again transferred to the first compound are smoothly performed.

Fig. 1 illustrates LUMO electron orbitals obtained by the molecular orbital calculation of the first compound and the second compound of Exemplary Embodiment 1-2 and Comparative Example E shown in Table 3. As illustrated in Fig. 1, the first and second compounds with a common partial structure have a similar distribution of the LUMO electron orbital and therefore have large overlap of their LUMO wave functions, which facilitates charge transfer between the compounds. On the other hand, in Comparative Example E, as illustrated in Fig. 1, the first compound and the second compound with a different structure have a different distribution of the LUMO electron orbital and therefore have a different LUMO wave function, which results in small overlap of their LUMO wave functions and hinders charge transfer between the compounds. This barrier leads to the accumulation of electric charges, increases the collision probability of electric charges with excitons generated in the light-emitting layer, causes extinction of the excitons, and reduces the lifetime.

The present inventors have found from the above that the effect of improving the durability of an element can be obtained by configuring the light-emitting layer to contain the second compound that has the same partial structure as the first compound, has higher electron acceptability than the first compound, and is not involved in light emission and thereby controlling charge injection into the light-emitting layer and reducing the collision probability between electric charges and excitons.

The calculation results were visualized using molecular orbital calculation. The calculation method in the molecular orbital calculation method utilized a widely used density functional theory (DFT). B3LYP was used as the functional, and 6-31G* was used as the basis function. The molecular orbital calculation method was performed using widely used Gaussian 09 (Gaussian 09, Revision C. 01, M.J. Frisch, G.W. Trucks, H.B. Schlegel, G.E. Scuseria, M.A. Robb, J.R. Cheeseman, G. Scalmani, V. Barone, B. Mennucci, G.A. Petersson, H. Nakatsuji, M. Caricato, X. Li, H.P. Hratchian, A.F. Izmaylov, J. Bloino, G. Zheng, J.L. Sonnenberg, M. Hada, M. Ehara, K. Toyota, R. Fukuda, J. Hasegawa, M. Ishida, T. Nakajima, Y. Honda, O. Kitao, H. Nakai, T. Vreven, J.A. Montgomery, Jr., J.E. Peralta, F. Ogliaro, M. Bearpark, J.J. Heyd, E. Brothers, K.N. Kudin, V.N. Staroverov, T. Keith, R. Kobayashi, J. Normand, K. Raghavachari, A. Rendell, J.C. Burant, S.S. Iyengar, J. Tomasi, M. Cossi, N. Rega, J.M. Millam, M. Klene, J.E. Knox, J.B. Cross, V. Bakken, C. Adamo, J. Jaramillo, R. Gomperts, R.E. Stratmann, O. Yazyev, A.J. Austin, R. Cammi, C. Pomelli, J.W. Ochterski, R.L. Martin, K. Morokuma, V.G. Zakrzewski, G.A. Voth, P. Salvador, J.J. Dannenberg, S. Dapprich, A.D. Daniels, O. Farkas, J.B. Foresman, J.V. Ortiz, J. Cioslowski, and D.J. Fox, Gaussian, Inc., Wallingford CT, 2010.).

The general formula [1], which represents the first compound according to the present disclosure, and the general formula [2], which represents the second compound according to the present disclosure, are described in detail below.

In the general formula [1] and the general formula [2], $R_1$ to $R_7$ are each independently selected from the group consisting of a hydrogen atom, deuterium, a linear, branched, or cyclic substituted or unsubstituted alkyl group, a substituted or unsubstituted aryl group, and a substituted or unsubstituted heterocyclic group, and the ring Ar1 denotes a substituted or unsubstituted tricyclic or higher cyclic fused group.

The alkyl group can be an alkyl group with 1 to 10 carbon atoms. More specifically, the alkyl group may be a methyl group, an ethyl group, a n-propyl group, a n-butyl group, a n-pentyl group, a n-hexyl group, a n-heptyl group, a n-octyl group, a n-decyl group, an iso-propyl group, an iso-butyl group, a sec-butyl group, a tert-butyl group, an iso-pentyl group, a

neopentyl group, a tert-octyl group, a cyclopropyl group, a cyclobutyl group, a cyclopentyl group, a cyclohexyl group, a cyclopentylmethyl group, a cyclohexylmethyl group, a cyclohexylethyl group, a 4-fluorocyclohexyl group, a norbornyl group, or an adamantyl group. The alkyl group may have a substituent or a halogen atom. The halogen atom, if present, can be a fluorine atom. Specific examples thereof include a fluoromethyl group, a difluoromethyl group, a trifluoromethyl group, a 2-fluoroethyl group, a 2,2,2-trifluoroethyl group, a perfluoroethyl group, a 3-fluoropropyl group, a perfluoropropyl group, a 4-fluorobutyl group, a perfluorobutyl group, a 5-fluoropentyl group, and a 6-fluorohexyl group.

The aryl group can be an aryl group with 6 to 24 carbon atoms. More specifically, the aryl group may be, but is not limited to, a phenyl group, a naphthyl group, an indenyl group, a biphenyl group, a terphenyl group, a fluorenyl group, an anthryl group, a phenanthryl group, a pyrenyl group, a tetracenyl group, a pentacenyl group, a triphenylenyl group, or a perylenyl group.

The heterocyclic group can be a heterocyclic group with 3 to 21 carbon atoms. The heteroatom may be oxygen, nitrogen, sulfur, or the like. More specifically, the heterocyclic group may be, but is not limited to, a thienyl group, a pyrrolyl group, a pyridyl group, a pyrazyl group, a pyrimidyl group, a pyridazinyl group, a quinolinyl group, an isoquinolinyl group, an oxazolyl group, an oxadiazolyl group, a phenanthridinyl group, an acridinyl group, a naphthyridinyl group, a quinoxalinyl group, a quinazolinyl group, a cinnolinyl group, a phthalazinyl group, a phenanthrolyl group, a phenazinyl group, a dibenzofuranyl group, a dibenzothiophenyl group, a carbazolyl group, a benzofuranyl group, a benzothiophenyl group, an indolyl group, a cycloazinyl group, a benzimidazolyl group, a benzothiazolyl group, or a benzothiadiazolyl.

The tricyclic or higher cyclic fused group is bonded to the naphthalene skeleton as a monovalent substituent in the general formula [1] and as a divalent substituent in the general formula [2]. Thus, the monovalent and divalent tricyclic or higher cyclic fused group in the general formulae [1] and [2] are collectively referred to as a fused polycyclic name + group. Fused polycyclic groups include, but are not limited to, anthracene groups, phenanthrene groups, pyrene groups, fluoranthene groups, benzophenanthrene groups, tetracene groups, pentacene groups, perylene groups, and the like.

In the general formulae [1] and [2], the substituent, that is, the additional substituent of the alkyl group, the aryl group, the heterocyclic group, or the fused polycyclic group is, for example, an alkyl group with 1 to 6 carbon atoms, such as a methyl group, an ethyl group, a propyl group, or a butyl group, an aralkyl group, such as a benzyl group, an aryl group with 6 to 12 carbon atoms, such as a phenyl group or a biphenyl group, a heterocyclic group with 3 to 9 carbon atoms, such as a pyridyl group, a pyrrolyl group, a benzimidazolyl group, or a benzothiazolyl group, an amino group, such as a dimethylamino group, a diethylamino group, a dibenzylamino group, a diphenylamino group, or a ditolylamino group, an alkoxy group, such as a methoxy group, an ethoxy group, a propoxy group, or a phenoxy group, a cyano group, a halogen atom, such as a fluorine atom, or deuterium. A heteroatom in the heterocyclic group may be oxygen, nitrogen, or sulfur.

The first compound according to the present disclosure can be a compound represented by the following general formula [3], and the second compound according to the present disclosure can be a compound represented by the following general formula [4]. $R_5$ can be a pyrenyl group, or $R_6$ can be any one of a fluorenyl group, a naphthyl group, a phenyl group, and a dibenzothiophenyl group.

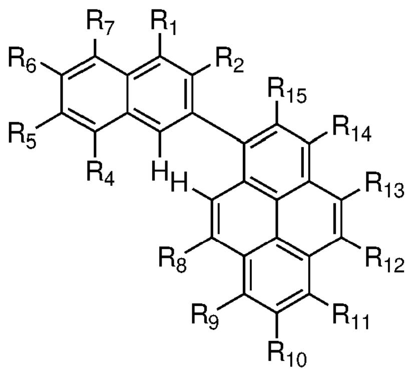
[3]

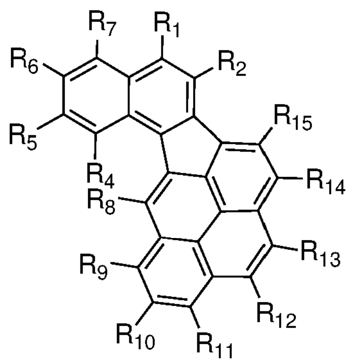
[4]

In the general formulae [3] and [4], $R_1$, $R_2$, and $R_4$ to $R_{15}$ are each independently selected from the group consisting of a hydrogen atom, a linear, branched, or cyclic alkyl group, a substituted or unsubstituted aryl group, and a substituted or unsubstituted heterocyclic group. The examples of the alkyl group, the aryl group, and the heterocyclic group are the same as the examples of the alkyl group, the aryl group, and the heterocyclic group in the general formulae [1] and [2].

Specific examples of the first compound and the second compound according to the present disclosure are described below. However, the present disclosure is not limited these examples.

Table.4

| | First organic compound | Second organic compound |
|---|---|---|
| Exemplary embodiment A1 | 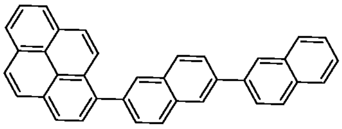 A1-1 | 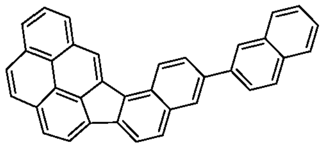 A1-2 |
| Exemplary embodiment A2 | 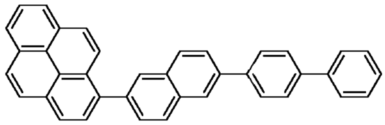 A2-1 | 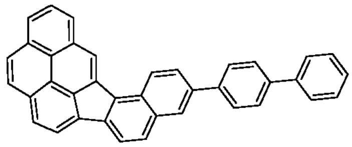 A2-2 |
| Exemplary embodiment A3 | 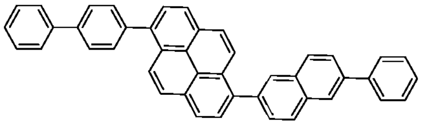 A3-1 | 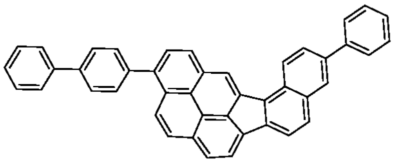 A3-2 |
| Exemplary embodiment A4 | 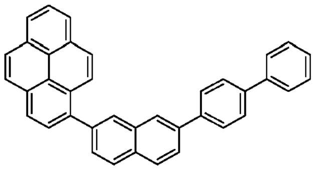 A4-1 | 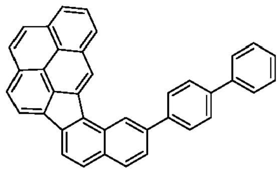 A4-2 |
| Exemplary embodiment A5 | 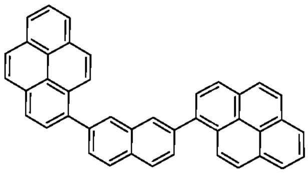 A5-1 | 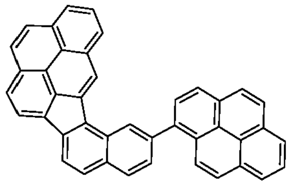 A5-2 |
| Exemplary embodiment A6 | 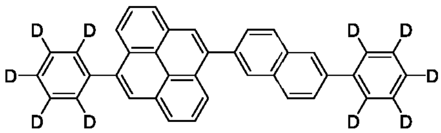 A6-1 | 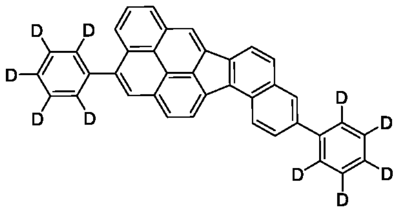 A6-2 |
| Exemplary embodiment A7 | 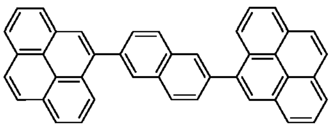 A7-1 | 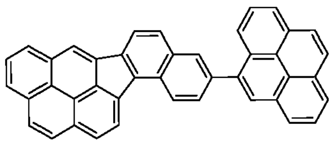 A7-2 |

(continued)

| | First organic compound | Second organic compound |
|---|---|---|
| Exemplary embodiment A8 | 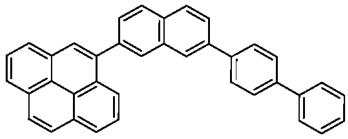 A8-1 | 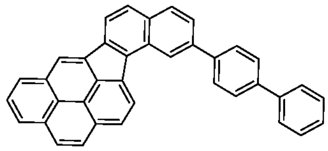 A8-2 |

Table.5

| | First organic compound | Second organic compound |
|---|---|---|
| Exemplary embodiment B1 | 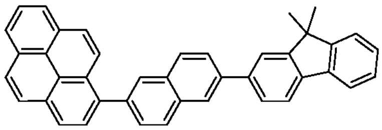 B1-1 | 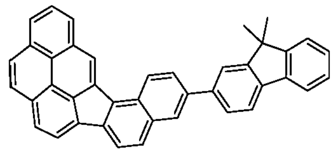 B1-2 |
| Exemplary embodiment B2 | 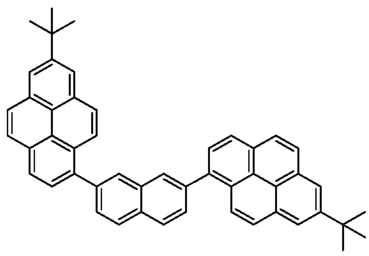 B2-1 | 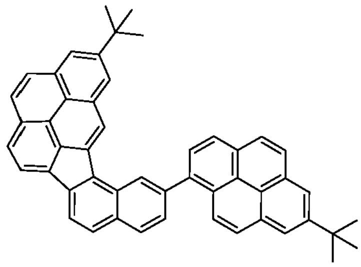 B2-2 |
| Exemplary embodiment B3 | 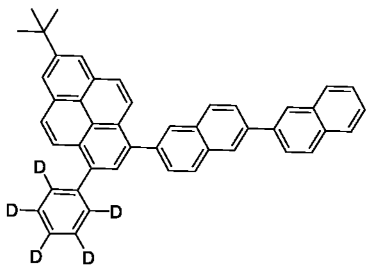 B3-1 | 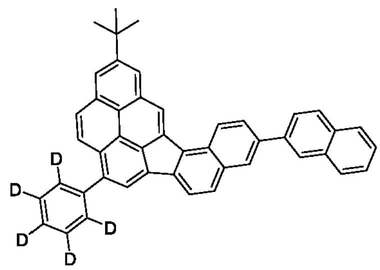 B3-2 |
| Exemplary embodiment B4 | 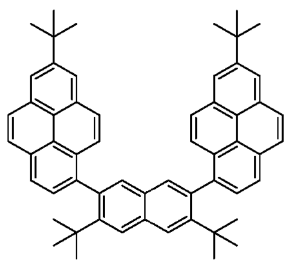 B4-1 | 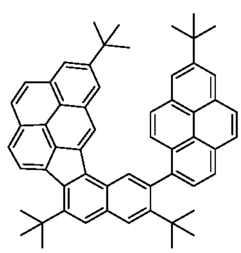 B4-2 |

(continued)

| | First organic compound | Second organic compound |
|---|---|---|
| Exemplary embodiment B5 | 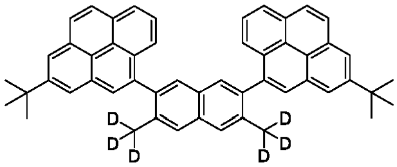 B5-1 | 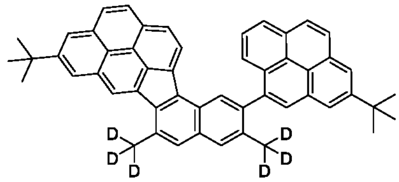 B5-2 |

Table.6

| | First organic compound | Second organic compound |
|---|---|---|
| Exemplary embodiment C1 | 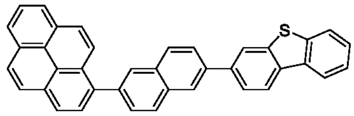 C1-1 | 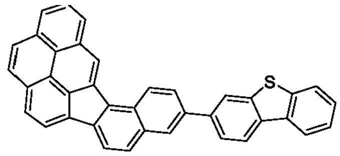 C1-2 |
| Exemplary embodiment C2 | 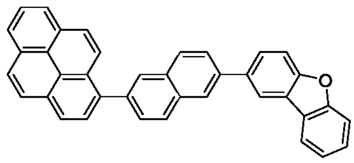 C2-1 | 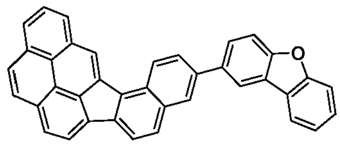 C2-1 |
| Exemplary embodiment C3 | 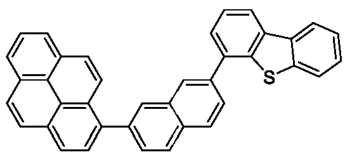 C3-1 | 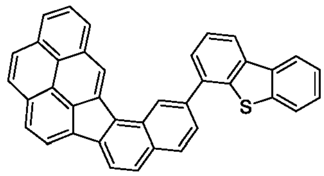 C3-2 |
| Exemplary embodiment C4 | 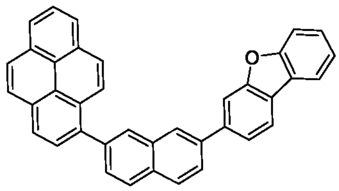 C4-1 | 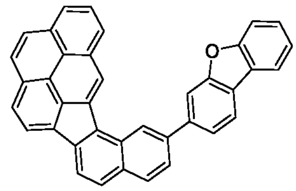 C4-2 |
| Exemplary embodiment C5 | 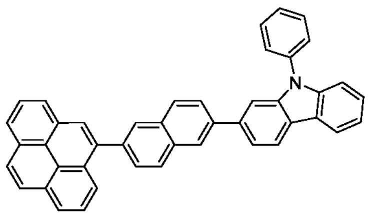 C5-1 | 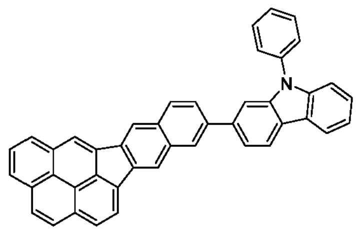 C5-2 |

(continued)

| | First organic compound | Second organic compound |
|---|---|---|
| Exemplary embodiment C6 | 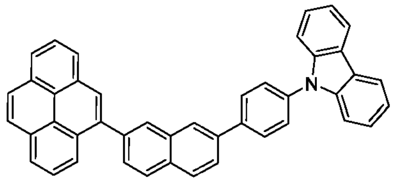 C6-1 | 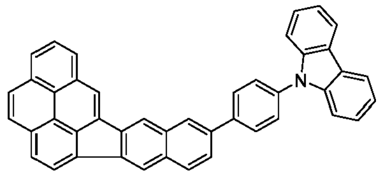 C6-2 |
| Exemplary embodiment C7 | 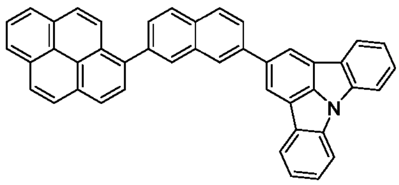 C7-1 | 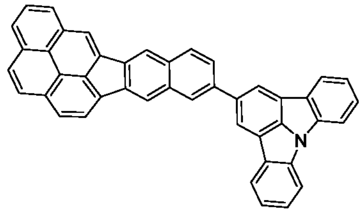 C7-2 |

Table.7

| | First organic compound | Second organic compound |
|---|---|---|
| Exemplary embodiment D1 | 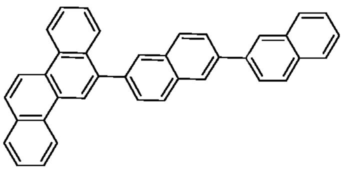 D1-1 | 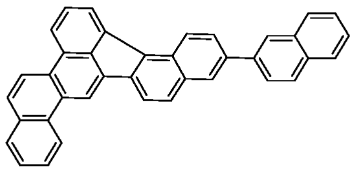 D1-2 |
| Exemplary embodiment D2 | 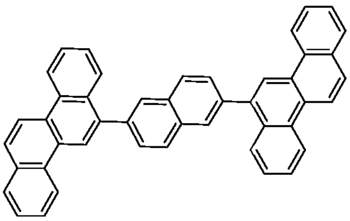 D2-1 | 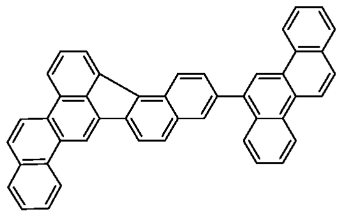 D2-2 |
| Exemplary embodiment D3 | 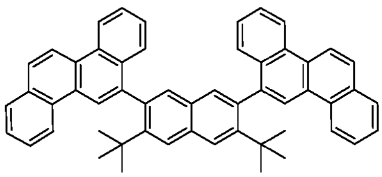 D3-1 | 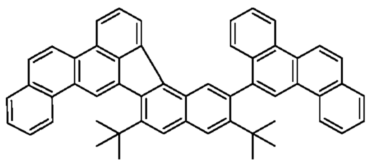 D3-2 |
| Exemplary embodiment E1 | 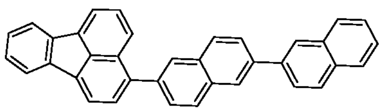 E1-1 | 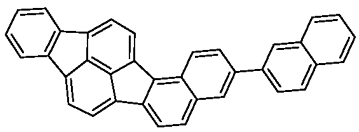 E1-2 |

(continued)

| | First organic compound | Second organic compound |
|---|---|---|
| Exemplary embodiment E2 | 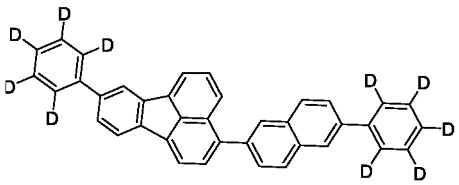 E2-1 | 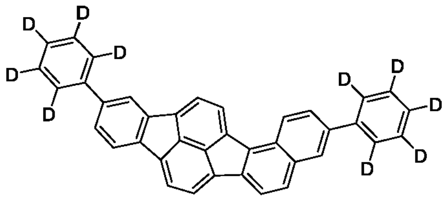 E2-2 |

Table.8

| | First organic compound | Second organic compound |
|---|---|---|
| Exemplary embodiment F1 | 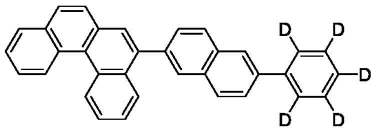 F1-1 | 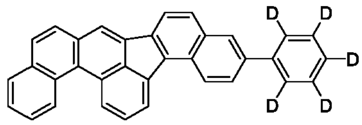 F1-2 |
| Exemplary embodiment F2 | 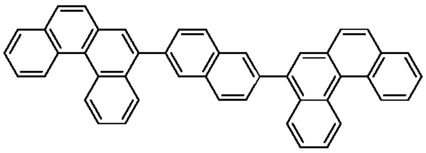 F2-1 | 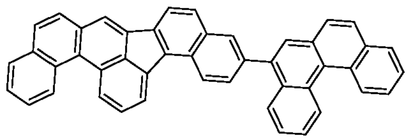 F2-2 |
| Exemplary embodiment G1 | 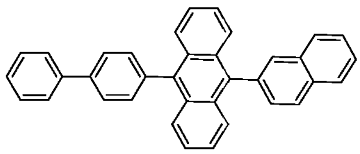 G1-1 | 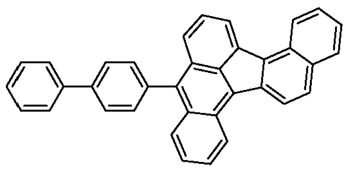 G1-2 |
| Exemplary embodiment G2 | 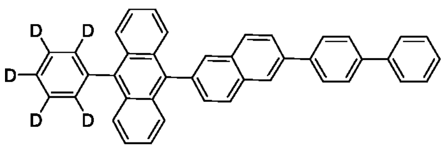 G2-1 | 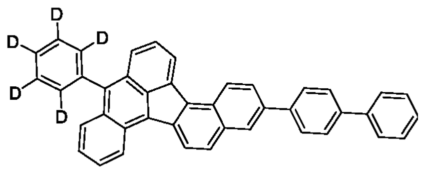 G2-2 |

Among these exemplary compounds, the exemplary compounds belonging to Group A are compounds in which Ar1 in the general formula [1] and the general formula [2] is a pyrene group and that have no $sp^3$ ($sp^3$ hybrid orbital) carbon, and are organic compounds with high stability against holes and electrons.

Among the exemplary compounds, the exemplary compounds belonging to Group B are compounds in which Ar1 in the general formula [1] and the general formula [2] is a pyrene group and that have an alkyl group as a substituent, and have high sublimability. It is also possible to lower the voltage of an organic light-emitting element containing such an exemplary compound in a light-emitting layer.

Among the exemplary compounds, the exemplary compounds belonging to Group C are compounds in which Ar1 in the general formula [1] and the general formula [2] is a pyrene group and that have a heteroatom in a fused ring, and have good charge-transport characteristics.

Among the exemplary compounds, the exemplary compounds belonging to Group D have a chrysene group as Ar1 in the general formula [1] and the general formula [2] and have high heat resistance.

Among the exemplary compounds, the exemplary compounds belonging to Group E have a fluoranthene group as Ar1 in the general formula [1] and the general formula [2] and have high electron acceptability.

Among the exemplary compounds, the exemplary compounds belonging to Group F have a benzophenanthrene

group as Ar1 in the general formula [1] and the general formula [2] and have high heat resistance.

Among the exemplary compounds, the exemplary compounds belonging to Group G have an anthracene group as Ar1 in the general formula [1] and the general formula [2] and have good charge-transport characteristics.

An organic light-emitting element according to the present embodiment includes at least a pair of electrodes, a positive electrode and a negative electrode, and an organic compound layer between the electrodes. In the organic light-emitting element according to the present embodiment, the organic compound layer may be a single layer or a laminate of a plurality of layers, provided that the organic compound layer has a light-emitting layer. The term "a plurality of layers", as used herein, refers to a laminate of a light-emitting layer and another light-emitting layer. The "laminate" indicates that organic compound layers are stacked from one electrode to the other electrode.

When the organic compound layer is a laminate of a plurality of layers, the organic compound layer may have a hole-injection layer, a hole-transport layer, an electron-blocking layer, a hole-blocking layer, an electron-transport layer, and/or an electron-injection layer, in addition to a light-emitting layer. The light-emitting layer may be a single layer or a laminate of a plurality of layers. When the organic compound layer is a plurality of layers, the organic compound layer may be, from the positive electrode side, a hole-injection layer, a hole-transport layer, an electron-blocking layer, a light-emitting layer, a hole-blocking layer, an electron-transport layer, and an electron-injection layer.

The electron-blocking layer can have a higher LUMO level than the light-emitting layer. This is to suppress electron transfer from the light-emitting layer to the positive electrode side. HOMO and LUMO refer to the highest occupied molecular orbital and the lowest unoccupied molecular orbital, respectively, and their energy levels are referred to as a HOMO level and a LUMO level, respectively. The HOMO level and the LUMO level may also be referred to as HOMO and LUMO, respectively. A higher HOMO level or a higher LUMO level indicates a state closer to the vacuum level. A high HOMO level is also referred to as a shallow HOMO level. The same is true for the LUMO level.

The organic compound layer of the organic light-emitting element according to the present embodiment contains the first compound represented by the general formula [1] and the second compound represented by the general formula [2] in at least one layer. More specifically, the first and second compounds are contained in any of the light-emitting layer, the hole-injection layer, the hole-transport layer, the electron-blocking layer, the hole-blocking layer, the electron-transport layer, the electron-injection layer, and the like described above. The first and second compounds can be contained in the light-emitting layer.

In the organic light-emitting element according to the present embodiment, when the first and second compounds are contained in the light-emitting layer, a light-emitting material is contained as a third compound. More specifically, the first compound is a host, the second compound is an assist, and the third compound is a guest. In addition to the light-emitting layer containing the first and second compounds and the light-emitting material, a second light-emitting layer may be provided, and the second light-emitting layer can be located on the positive electrode side.

The host is a compound with the highest weight ratio among the compounds constituting a light-emitting layer. The guest is a compound that has a lower weight ratio than the host among the compounds constituting a light-emitting layer and that is a principal light-emitting compound. The guest is sometimes referred to as a dopant. The assist is a compound that has a lower weight ratio than the host among the compounds constituting a light-emitting layer and that assists the guest in emitting light. The assist is also referred to as a second host. When the first compound is used as a host and the second compound is used as an assist, the second compound content is preferably more than 0 and less than 0.2% by weight, preferably less than 0.1% by weight, with respect to 100% by weight of the total weight of the first compound and the second compound.

The total content of the first compound and the second compound in the light-emitting layer is preferably 80% by weight or more and 99% by weight or less in the light-emitting layer.

The present inventors have conducted various studies and found that the first compound represented by the general formula [1] and the second compound represented by the general formula [2] can be used in combination in an organic compound layer of an organic light-emitting element to produce an element with high durability. The organic compound layer has a light-emitting layer, and the light-emitting layer may contain a light-emitting material with a plurality of emission colors. A light-emitting element can emit white light by a combination of a plurality of emission colors.

The organic light-emitting element according to the present embodiment may have a structure other than those described above. For example, an insulating layer, an adhesive layer, or an interference layer may be provided at an interface between an electrode and an organic compound layer, or an electron-transport layer or a hole-transport layer may be formed of two layers with different ionization potentials.

The light extraction structure of an organic light-emitting element may be a top emission structure of extracting light from an electrode on the side opposite to a substrate, a bottom emission structure of extracting light from the substrate side, or a structure of extracting light from both sides. To extract light from the substrate side, the substrate and the electrode on the substrate side can be optically transparent. To extract light from the side opposite to the substrate, the electrode on the side opposite to the substrate can be optically transparent.

In the organic light-emitting element according to the present embodiment, in addition to the first compound represented by the general formula [1] and the second compound represented by the general formula [2], a known

compound can also be used as required. More specifically, the known compound may be a low-molecular-weight or high-molecular-weight hole-injection or hole-transport compound, a compound serving as a host, a light-emitting material, an electron-injection compound, an electron-transport compound, or the like. Examples of these compounds are described below.

The hole-injection/transport material can be a material with high hole mobility to facilitate the injection of holes from a positive electrode and to transport the injected holes to a light-emitting layer. Furthermore, a material with a high glass transition temperature can be used to reduce degradation of film quality, such as crystallization, in an organic light-emitting element.

Examples of the low-molecular-weight or high-molecular-weight material with hole-injection/transport ability include, but are not limited to, triarylamine derivatives, aryl carbazole derivatives, phenylenediamine derivatives, stilbene derivatives, phthalocyanine derivatives, porphyrin derivatives, polyvinylcarbazole, polythiophene, and other electrically conductive polymers. The hole-injection/transport material can also be used for an electron-blocking layer.

Specific examples of compounds that can be used as hole-injection/transport materials include, but are not limited to, the following.

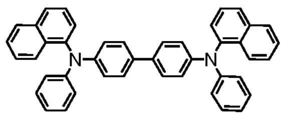

HT1

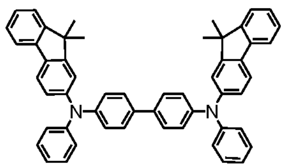

HT2

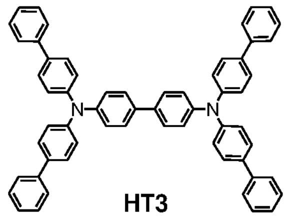

HT3

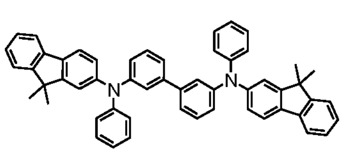

HT4

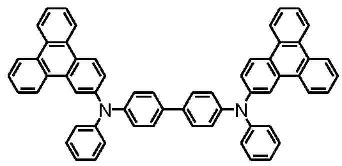

HT5

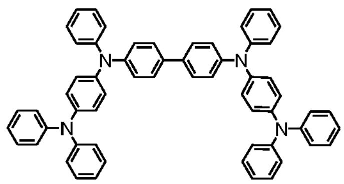

HT6

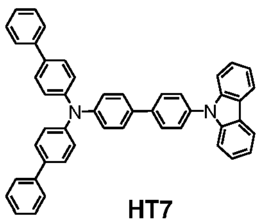

HT7

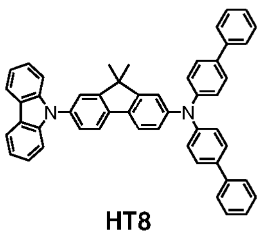

HT8

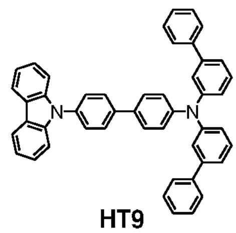

HT9

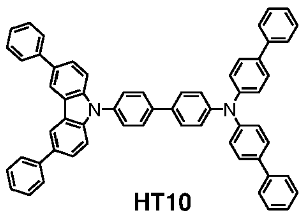

HT10

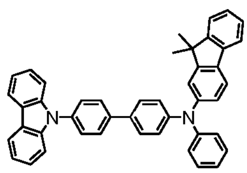

HT11

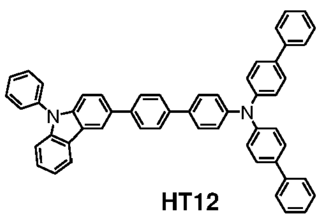

HT12

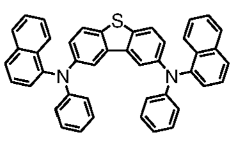

HT13

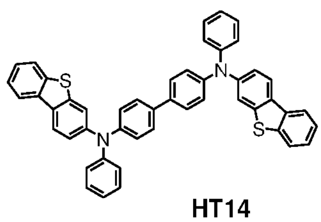

HT14

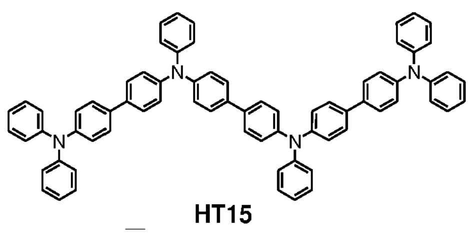

HT15

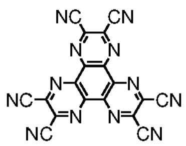
HT16

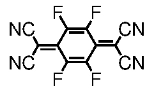
HT17

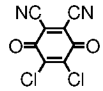
HT18

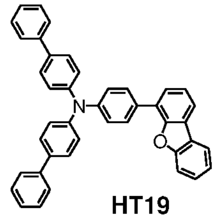
HT19

Among those described above, HT16 to HT18 can be used for a layer in contact with the positive electrode to decrease drive voltage. HT16 is widely used for organic light-emitting elements. HT2, HT3, HT10, or HT12 may be used for an organic compound layer adjacent to HT16. Furthermore, a plurality of materials may be used for one organic compound layer. For example, a combination of HT2 and HT4, HT3 and HT10, or HT8 and HT9 may be used.

A light-emitting material mainly related to the light-emitting function may be a fused-ring compound (for example, a fluorene derivative, a naphthalene derivative, a pyrene derivative, a perylene derivative, a tetracene derivative, an anthracene compound, rubrene, or the like), a quinacridone derivative, a coumarin derivative, a stilbene derivative, an organoaluminum complex, such as tris(8-quinolinolato)aluminum, an iridium complex, a platinum complex, a rhenium complex, a copper complex, an europium complex, a ruthenium complex, or a polymer derivative, such as a poly(phenylene vinylene) derivative, a polyfluorene derivative, or a polyphenylene derivative. A derivative of a compound is one in which the skeleton of the compound can be found in the structure. For example, the following BD3 can be referred to as a fluorene derivative. BD6, BD7, GD4, and RD1 can be referred to as fluoranthene derivatives. GD1, GD2, and GD3 can be referred to as anthracene derivatives. GD4 is an anthracene derivative and a pyrene derivative. In particular, a fluoranthene derivative, an anthracene derivative, or a pyrene derivative can be used. When a plurality of light-emitting materials are used, all the light-emitting materials can be a fluoranthene derivative, an anthracene derivative, or a pyrene derivative.

Specific examples of compounds that can be used as light-emitting materials include, but are not limited to, the following.

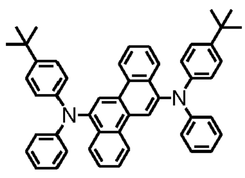
BD1

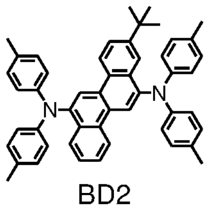
BD2

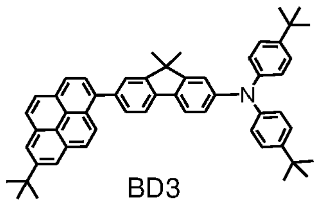
BD3

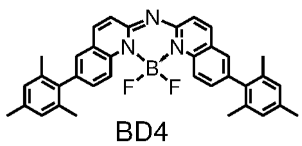
BD4

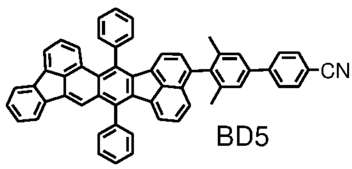
BD5

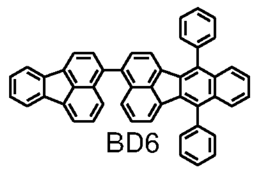
BD6

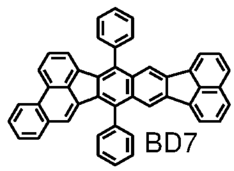
BD7

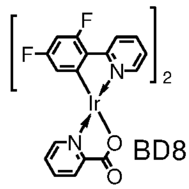
BD8

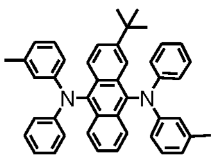
GD1

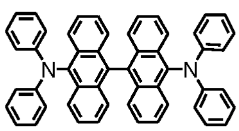
GD2

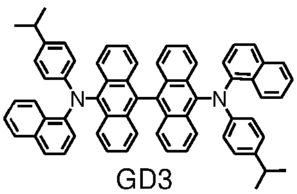
GD3

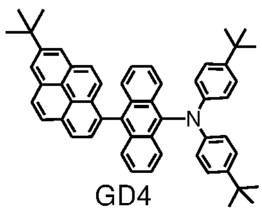
GD4

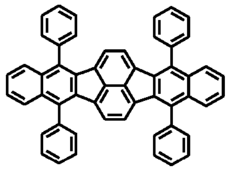
GD5
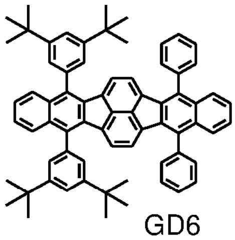
GD6
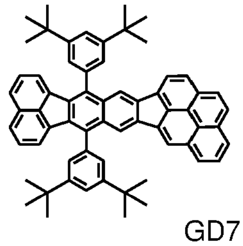
GD7
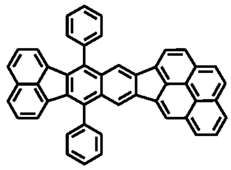
GD8

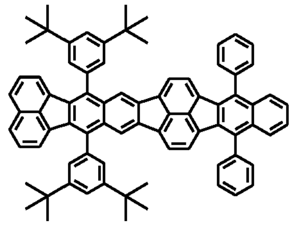
GD9
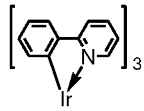
GD10
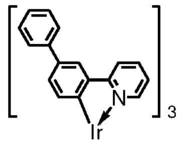
GD11
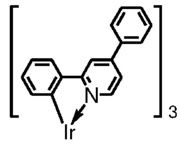
GD12

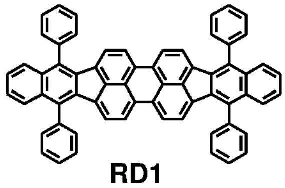
**RD1**
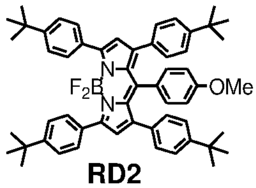
**RD2**
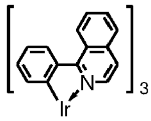
**RD3**
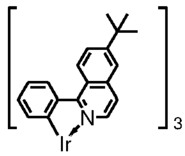
**RD4**

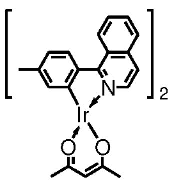
**RD5**
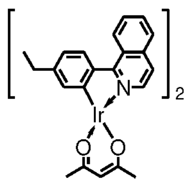
**RD6**
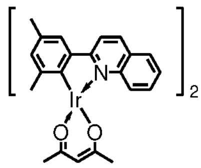
**RD7**
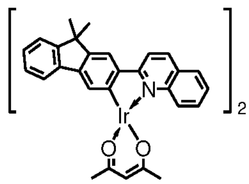
**RD8**

A host or an assist in the light-emitting layer may be a carbazole derivative, a dibenzofuran derivative, a dibenzothiophene derivative, an organoaluminum complex, such as tris(8-quinolinolato)aluminum, or an organoberyllium complex. These compounds are also suitable for use in the hole-blocking layer.

Specific examples of compounds that can be used as a host in the light-emitting layer are described below. However, the present disclosure is not limited to these examples.

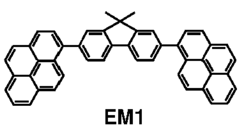
**EM1**
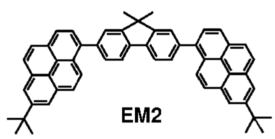
**EM2**
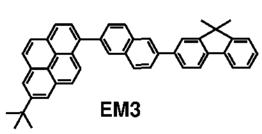
**EM3**
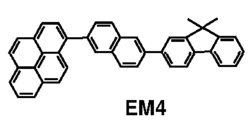
**EM4**

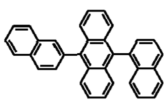
**EM5**
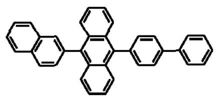
**EM6**
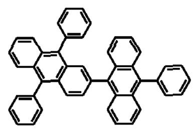
**EM7**
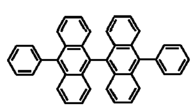
**EM8**

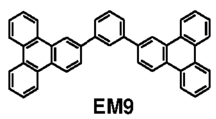
**EM9**
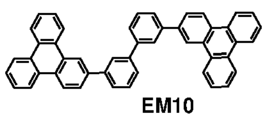
**EM10**
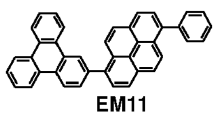
**EM11**
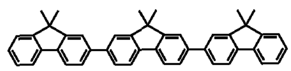
**EM12**

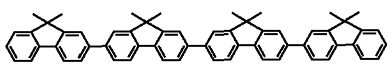
EM13

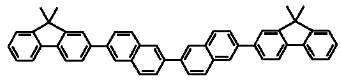
EM14

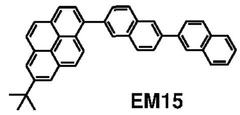
EM15

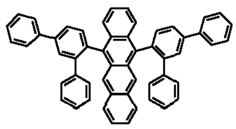
EM16

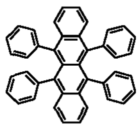
EM17

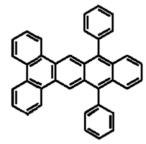
EM18

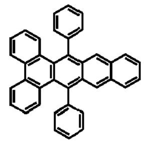
EM19

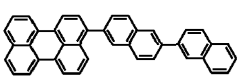
EM20

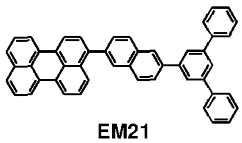
EM21

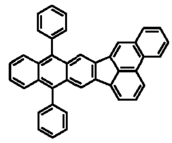
EM22

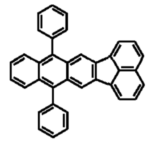
EM23

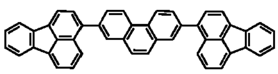
EM24

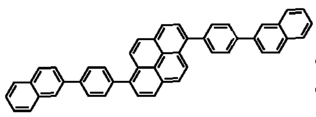
EM25

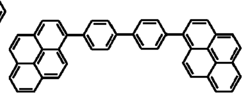
EM26

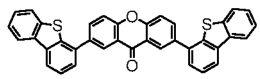
EM27

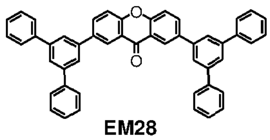
EM28

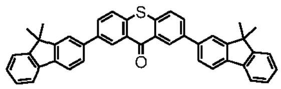
EM29

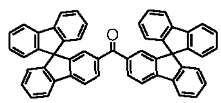
EM30

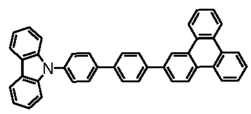
EM31

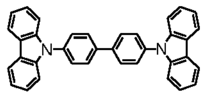
EM32

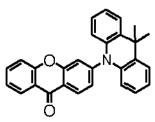
EM33

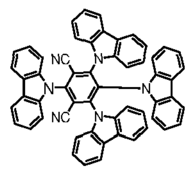
EM34

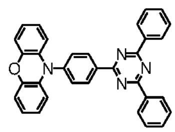
EM35

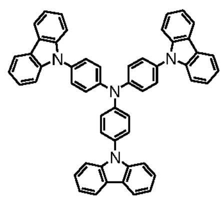
EM36

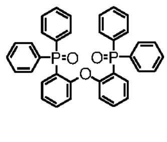
EM37

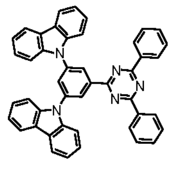
EM38

An electron-transport material can be selected from materials that can transport electrons injected from the negative electrode to the light-emitting layer and is selected in consideration of the balance with the hole mobility of a hole-transport material and the like. Examples of materials with electron-transport ability include, but are not limited to, oxadiazole derivatives, oxazole derivatives, pyrazine derivatives, triazole derivatives, triazine derivatives, quinoline derivatives, quinoxaline derivatives, phenanthroline derivatives, organoaluminum complexes, and fused-ring compounds (for example, fluorene derivatives, naphthalene derivatives, chrysene derivatives, and anthracene derivatives). Furthermore, the electron-transport material is also suitable for use in a hole-blocking layer. Specific examples of compounds that can be used as electron-transport materials include, but are not limited to, the following.

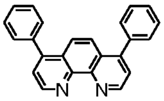
ET1
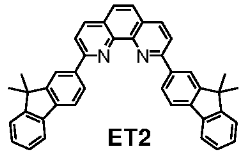
ET2
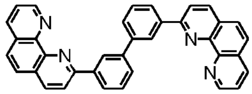
ET3
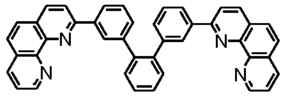
ET4

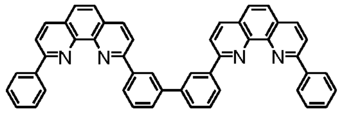
ET5
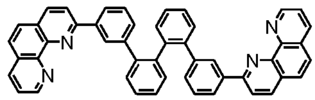
ET6
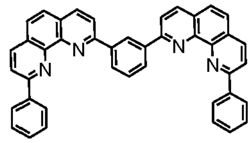
ET7

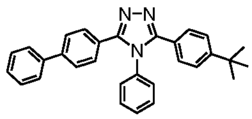
ET8
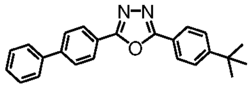
ET9
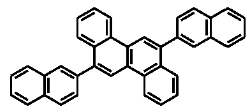
ET10
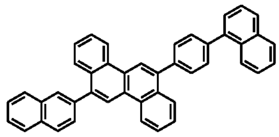
ET11

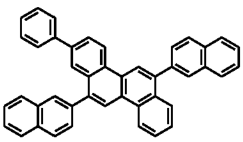
ET12
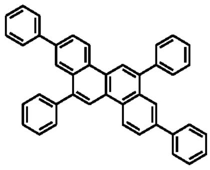
ET13
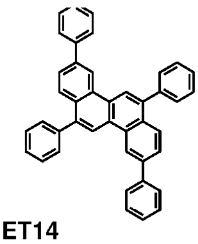
ET14
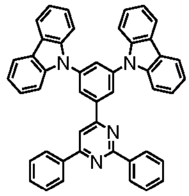
ET15

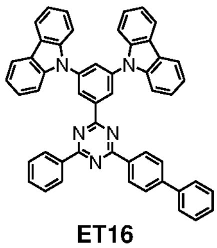
ET16
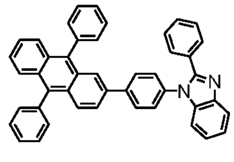
ET17
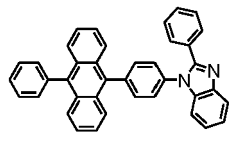
ET18
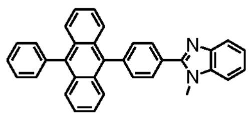
ET19

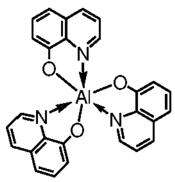
ET20
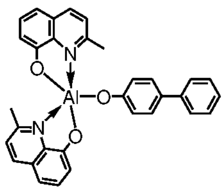
ET21
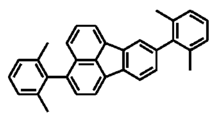
ET22
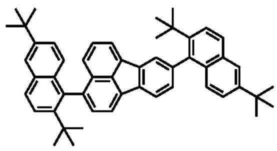
ET23

The electron-injection material can be selected from materials that can easily inject electrons from the negative electrode and is selected in consideration of the balance with the hole injection properties and the like. The organic compound may be an n-type dopant or a reducing dopant. Examples include compounds containing an alkali metal, such as lithium fluoride, lithium complexes, such as lithium quinolinol, benzimidazolidene derivatives, imidazolidene derivatives, fulvalene derivatives, and acridine derivatives.

<Structure of Organic Light-Emitting Element>

An organic light-emitting element includes an insulating layer, a first electrode, an organic compound layer, and a second electrode on a substrate. A protective layer, a color filter, a microlens, or the like may be provided on the second electrode. When a color filter is provided, a planarization layer may be provided between the color filter and a protective

layer. The planarization layer may be composed of an acrylic resin or the like. The same applies to a planarization layer provided between a color filter and a microlens.

[Substrate]

The substrate may be formed of quartz, glass, a silicon wafer, resin, metal, or the like. The substrate may have a switching element, such as a transistor, and wiring, on which an insulating layer may be provided. The insulating layer may be composed of any material, provided that the insulating layer can have a contact hole for wiring between the insulating layer and the first electrode and is insulated from unconnected wires. For example, the insulating layer may be formed of a resin, such as polyimide, silicon oxide, or silicon nitride.

[Electrodes]

A pair of electrodes can be used as electrodes. The pair of electrodes may be a positive electrode and a negative electrode. When an electric field is applied in a direction in which the organic light-emitting element emits light, an electrode with a high electric potential is a positive electrode, and the other electrode is a negative electrode. In other words, the electrode that supplies holes to the light-emitting layer is a positive electrode, and the electrode that supplies electrons to the light-emitting layer is a negative electrode.

A constituent material of the positive electrode can have as large a work function as possible. Examples of the constituent material include metal elements, such as gold, platinum, silver, copper, nickel, palladium, cobalt, selenium, vanadium, and tungsten, mixtures thereof, alloys thereof, and metal oxides, such as tin oxide, zinc oxide, indium oxide, indium tin oxide (ITO), and indium zinc oxide. Electrically conductive polymers, such as polyaniline, polypyrrole, and polythiophene, may also be used.

These electrode materials may be used alone or in combination. The positive electrode may be composed of a single layer or a plurality of layers.

When used as a reflective electrode, for example, chromium, aluminum, silver, titanium, tungsten, molybdenum, an alloy thereof, or a laminate thereof can be used. These materials can also function as a reflective film that does not have a role as an electrode. When used as a transparent electrode, an oxide transparent conductive layer, such as indium tin oxide (ITO) or indium zinc oxide, can be used. However, the present disclosure is not limited thereto. The electrodes may be formed by photolithography.

A constituent material of the negative electrode can be a material with a small work function. For example, an alkali metal, such as lithium, an alkaline-earth metal, such as calcium, a metal element, such as aluminum, titanium, manganese, silver, lead, or chromium, or a mixture thereof may be used. An alloy of these metal elements may also be used. For example, magnesium-silver, aluminum-lithium, aluminum-magnesium, silver-copper, or zinc-silver may be used. A metal oxide, such as indium tin oxide (ITO), may also be used. These electrode materials may be used alone or in combination. The negative electrode may be composed of a single layer or a plurality of layers. In particular, silver can be used, and a silver alloy can be used to reduce the aggregation of silver. As long as the aggregation of silver can be reduced, the alloy may have any ratio. For example, the ratio of silver to another metal may be 1:1, 3:1, or the like.

The negative electrode may be, but is not limited to, an oxide conductive layer, such as ITO, for a top emission element or a reflective electrode, such as aluminum (Al), for a bottom emission element. The negative electrode may be formed by any method. A direct-current or alternating-current sputtering method can achieve good film coverage and easily decrease resistance.

[Organic Compound Layer]

The organic compound layer includes at least a light-emitting layer and, in addition to the light-emitting layer, may include a hole-injection layer, a hole-transport layer, and/or an electron-blocking layer on the positive electrode side, and a hole-blocking layer, an electron-transport layer, and/or an electron-injection layer on the negative electrode side, which are appropriately selected as required. The organic compound layer is composed mainly of an organic compound and may contain an inorganic atom or an inorganic compound. For example, copper, lithium, magnesium, aluminum, iridium, platinum, molybdenum, zinc, or the like may be contained.

An organic compound layer constituting an organic light-emitting element according to an embodiment of the present disclosure can be formed by a dry process, such as a vacuum evaporation method, an ionized deposition method, sputtering, or plasma. Instead of the dry process, a wet process may also be employed in which a layer is formed by a known coating method (for example, spin coating, dipping, a casting method, an LB method, an ink jet method, or the like) using an appropriate solvent.

A layer formed by a vacuum evaporation method, a solution coating method, or the like undergoes little crystallization or the like and has high temporal stability. When a film is formed by a coating method, the film may also

be formed in combination with an appropriate binder resin.

Examples of the binder resin include, but are not limited to, polyvinylcarbazole resins, polycarbonate resins, polyester resins, ABS resins, acrylic resins, polyimide resins, phenolic resins, epoxy resins, silicone resins, and urea resins.

These binder resins may be used alone or in combination as a homopolymer or a copolymer. If necessary, an additive agent, such as a known plasticizer, oxidation inhibitor, and/or ultraviolet absorbent, may also be used.

[Protective Layer]

A protective layer may be provided on the second electrode. For example, a glass sheet with a moisture absorbent may be attached to the second electrode to decrease the amount of water or the like entering the organic compound layer and to reduce the occurrence of display defects. In another embodiment, a passivation film of silicon nitride or the like may be provided on the second electrode to decrease the amount of water or the like entering the organic compound layer. For example, the second electrode may be formed and then transferred to another chamber without breaking the vacuum, and a silicon nitride film with a thickness of 2 μm may be formed as a protective layer by a chemical vapor deposition (CVD) method. The film formation by the CVD method may be followed by the formation of a protective layer by an atomic layer deposition (ALD) method. A film formed by the ALD method may be formed of any material such as silicon nitride, silicon oxide, or aluminum oxide. Silicon nitride may be further formed by the CVD method on the film formed by the ALD method. The film formed by the ALD method may have a smaller thickness than the film formed by the CVD method. More specifically, the thickness may be 50% or less or even 10% or less.

[Color Filter]

A color filter may be provided on the protective layer. For example, a color filter that matches the size of the organic light-emitting element may be provided on another substrate and may be bonded to the substrate on which the organic light-emitting element is provided, or a color filter may be patterned on the protective layer by photolithography. The color filter may be composed of a polymer.

[Planarization Layer]

A planarization layer may be provided between the color filter and the protective layer. The planarization layer is provided to reduce the roughness of the underlayer. The planarization layer is sometimes referred to as a material resin layer with any purpose. The planarization layer may be composed of an organic compound and can be composed of a high-molecular-weight compound, though it may be composed of a low-molecular-weight compound.

The planarization layer may be provided above and below the color filter, and the constituent materials thereof may be the same or different. Specific examples include polyvinylcarbazole resins, polycarbonate resins, polyester resins, ABS resins, acrylic resins, polyimide resins, phenolic resins, epoxy resins, silicone resins, and urea resins.

[Microlens]

An organic light-emitting element or a light-emitting apparatus with an organic light-emitting element may include an optical member, such as a microlens, on the light output side. The microlens may be composed of an acrylic resin, an epoxy resin, or the like. The microlens may be used to increase the amount of light extracted from the organic light-emitting element or the light-emitting apparatus and control the direction of the extracted light. The microlens may have a hemispherical shape. For a hemispherical microlens, the vertex of the microlens is a contact point between the hemisphere and a tangent line parallel to the insulating layer among the tangent lines in contact with the hemisphere. The vertex of the microlens in a cross-sectional view can be determined in the same manner. More specifically, the vertex of the microlens in a cross-sectional view is a contact point between the semicircle of the microlens and a tangent line parallel to the insulating layer among the tangent lines in contact with the semicircle.

The midpoint of the microlens can also be defined. In a cross section of the microlens, a midpoint of a line segment from one end point to the other end point of the arc can be referred to as a midpoint of the microlens. A cross section in which the vertex and the midpoint are determined may be perpendicular to the insulating layer.

[Opposite Substrate]

An opposite substrate may be provided on the planarization layer. The opposite substrate is so called because it faces the substrate. The opposite substrate may be composed of the same material as the substrate. When the substrate is a first substrate, the opposite substrate may be a second substrate.

[Pixel Circuit]

A light-emitting apparatus including an organic light-emitting element may include a pixel circuit coupled to the organic light-emitting element. The pixel circuit may be of an active matrix type, which independently controls the light emission of a plurality of organic light-emitting elements. The active-matrix circuit may be voltage programmed or current programmed. The drive circuit has a pixel circuit for each pixel. The pixel circuit may include an organic light-emitting element, a transistor for controlling the luminous brightness of the organic light-emitting element, a transistor for controlling light emission timing, a capacitor for holding the gate voltage of the transistor for controlling the luminous brightness, and a transistor for GND connection without through the light-emitting element.

A light-emitting apparatus includes a display region and a peripheral region around the display region. The display region includes the pixel circuit, and the peripheral region includes a display control circuit. The mobility of a transistor constituting the pixel circuit may be smaller than the mobility of a transistor constituting the display control circuit. The gradient of the current-voltage characteristics of a transistor constituting the pixel circuit may be smaller than the gradient of the current-voltage characteristics of a transistor constituting the display control circuit. The gradient of the current-voltage characteristics can be determined by so-called Vg-Ig characteristics. A transistor constituting the pixel circuit is a transistor coupled to an organic light-emitting element.

[Pixel]

A light-emitting apparatus including an organic light-emitting element may have a plurality of pixels. Each pixel has subpixels that emit light of different colors. For example, the subpixels may have RGB emission colors.

In each pixel, a region also referred to as a pixel aperture emits light. This region is the same as the first region. The pixel aperture may be 15 μm or less or 5 μm or more. More specifically, the pixel aperture may be 11 μm, 9.5 μm, 7.4 μm, or 6.4 μm. The distance between the subpixels may be 10 μm or less, more specifically, 8 μm, 7.4 μm, or 6.4 μm.

The pixels may be arranged in a known form in a plan view. Examples include a stripe arrangement, a delta arrangement, a PenTile arrangement, and a Bayer arrangement. Each subpixel may have any known shape in a plan view. Examples include quadrangles, such as a rectangle and a rhombus, and a hexagon. As a matter of course, the rectangle also includes a figure that is not strictly rectangular but is close to rectangular. The shape of each subpixel and the pixel array can be used in combination.

<Applications of Organic Light-Emitting Element>

The organic light-emitting element according to the present embodiment can be used as a constituent of a display apparatus or a lighting apparatus. Other applications include an exposure light source for an electrophotographic image-forming apparatus, a backlight for a liquid crystal display, and a light-emitting apparatus with a color filter in a white light source.

The display apparatus may be an image-information-processing apparatus that includes an image input unit for inputting image information from an area CCD, a linear CCD, a memory card, or the like, includes an information processing unit for processing the input information, and displays an input image on a display unit. The display apparatus may have a plurality of pixels, and at least one of the pixels may include the organic light-emitting element according to the present embodiment and a transistor coupled to the organic light-emitting element.

A display unit of an imaging apparatus or an ink jet printer may have a touch panel function. A driving system of the touch panel function may be, but is not limited to, an infrared radiation system, an electrostatic capacitance system, a resistive film system, or an electromagnetic induction system. The display apparatus may be used for a display unit of a multifunction printer.

Next, a display apparatus according to the present embodiment is described with reference to the accompanying drawings.

Fig. 2A illustrates an example of a pixel serving as a constituent of the display apparatus according to the present embodiment. The pixel has subpixels 10. The subpixels are 10R, 10G, and 10B with different emission colors. The emission colors may be distinguished by the wavelength of light emitted from the light-emitting layer, or light emitted from each subpixel may be selectively transmitted or color-converted with a color filter or the like. Each of the subpixels 10 includes a reflective electrode serving as a first electrode 2, an insulating layer 3 covering an end of the first electrode 2, organic compound layers 4 covering the first electrode 2 and the insulating layer 3, a transparent electrode serving as a second electrode 5, a protective layer 6, and a color filter 7 on an interlayer insulating layer 1. Reference numeral 8 denotes an organic light-emitting element.

A transistor and/or a capacitor element may be provided under or inside the interlayer insulating layer 1. The transistor and the first electrode 2 may be electrically connected via a contact hole (not shown) or the like.

The insulating layer 3 is also referred to as a bank or a pixel separation film. The insulating layer 3 covers the ends

of the first electrode 2 and surrounds the first electrode 2. A portion not covered with the insulating layer 3 is in contact with the organic compound layers 4 and serves as a light-emitting region.

The second electrode 5 may be a transparent electrode, a reflective electrode, or a semitransparent electrode.

The protective layer 6 reduces the penetration of moisture into the organic compound layers 4. The protective layer 6 is illustrated as a single layer but may be a plurality of layers. The protective layer 6 may include an inorganic compound layer and an organic compound layer.

The color filter 7 is divided into 7R, 7G, and 7B according to the color. The color filter 7 may be formed on a planarization layer (not shown). Furthermore, a resin protective layer (not shown) may be provided on the color filter 7. The color filter 7 may be formed on the protective layer 6. Alternatively, the color filter 7 may be bonded after being provided on an opposite substrate, such as a glass substrate.

Fig. 2B is a schematic cross-sectional view of an example of a display apparatus that includes an organic light-emitting element and a transistor coupled to the organic light-emitting element. The display apparatus includes an organic light-emitting element 26 and a thin-film transistor (TFT) 18 as an example of a transistor. The display apparatus includes a substrate 11 made of glass, silicon, or the like and an insulating layer 12 on the substrate 11. An active element, such as the TFT 18, and a gate electrode 13, a gate-insulating film 14, and a semiconductor layer 15 of the active element are provided on the insulating layer 12. The TFT 18 is also composed of a drain electrode 16 and a source electrode 17. The TFT 18 is covered with an insulating film 19. A positive electrode 21 of the organic light-emitting element 26 is coupled to the source electrode 17 through a contact hole 20 formed in the insulating film 19.

Electrical connection between the electrodes of the organic light-emitting element 26 (the positive electrode 21 and a negative electrode 23) and the electrodes of the TFT 18 (the source electrode 17 and the drain electrode 16) is not limited to that illustrated in Fig. 2B. More specifically, it is only necessary to electrically connect either the positive electrode 21 or the negative electrode 23 to either the source electrode 17 or the drain electrode 16 of the TFT 18.

Although an organic compound layer 22 is a single layer in the display apparatus illustrated in Fig. 2B, the organic compound layer 22 may be composed of a plurality of layers. The negative electrode 23 is covered with a first protective layer 24 and a second protective layer 25 for reducing degradation of the organic light-emitting element 26.

The transistor used in the display apparatus in Fig. 2B is not limited to a transistor including a single crystal silicon wafer and may also be a thin-film transistor including an active layer on an insulating surface of a substrate. The active layer may be single-crystal silicon, non-single-crystal silicon, such as amorphous silicon or microcrystalline silicon, or a non-single-crystal oxide semiconductor, such as indium zinc oxide or indium gallium zinc oxide.

The transistor in the display apparatus of Fig. 2B may be formed within a substrate, such as a Si substrate. The phrase "formed within a substrate" means that the substrate, such as a Si substrate, itself is processed to form the transistor. Thus, the transistor within the substrate can be considered that the substrate and the transistor are integrally formed.

The luminous brightness of the organic light-emitting element 26 according to the present embodiment can be controlled by a TFT, which is an example of a switching element, and the organic light-emitting element 26 can be provided in a plurality of planes to display an image with their respective luminous brightness values. The switching element according to the present embodiment is not limited to the TFT and may be a transistor formed of low-temperature polysilicon or an active-matrix driver formed on a substrate, such as a Si substrate. "On a substrate" may also be referred to as "within a substrate". Whether a transistor is provided within a substrate or a TFT is used depends on the size of a display unit. For example, for an approximately 0.5-inch display unit, an organic light-emitting element can be provided on a Si substrate.

Fig. 3 is a schematic view of an example of the display apparatus according to the present embodiment. A display apparatus 1000 includes a touch panel 1003, a display panel 1005, a frame 1006, a circuit substrate 1007, and a battery 1008 between an upper cover 1001 and a lower cover 1009. The touch panel 1003 and the display panel 1005 are coupled to flexible print circuits FPC 1002 and 1004, respectively. Transistors are printed on the circuit substrate 1007. The battery 1008 is not necessarily provided when the display apparatus is not a mobile device, or may be provided at another position even when the display apparatus is a mobile device.

The display apparatus according to the present embodiment may include color filters of red, green, and blue colors. In the color filters, the red, green, and blue colors may be arranged in a delta arrangement.

The display apparatus according to the present embodiment may be used for a display unit of a mobile terminal. Such a display apparatus may have both a display function and an operation function. Examples of the mobile terminal include mobile phones, such as smartphones, tablets, and head-mounted displays.

The display apparatus according to the present embodiment may be used for a display unit of an imaging apparatus that includes an optical unit with a plurality of lenses and an imaging element for receiving light passing through the optical unit. The imaging apparatus may include a display unit for displaying information acquired by the imaging element. The display unit may be a display unit exposed outside from the imaging apparatus or a display unit located in a finder. The imaging apparatus may be a digital camera or a digital video camera.

Fig. 4A is a schematic view of an example of an imaging apparatus according to the present embodiment. An

imaging apparatus 1100 may include a viewfinder 1101, a rear display 1102, an operating unit 1103, and a housing 1104. The viewfinder 1101 includes the display apparatus according to the present embodiment. In this case, the display apparatus may display environmental information, imaging instructions, and the like as well as an image to be captured. The environmental information may include the intensity of external light, the direction of external light, the travel speed of the photographic subject, the possibility that the photographic subject is shielded by a shielding material, and the like.

Because the appropriate timing for imaging is a short time, it is better to display information as soon as possible. Thus, a display apparatus including the organic light-emitting element according to the present embodiment is used. This is because the organic light-emitting element has a high response speed. A display apparatus including the organic light-emitting element can be more suitably used than these apparatuses and liquid crystal displays that require a high display speed.

The imaging apparatus 1100 includes an optical unit (not shown). The optical unit has a plurality of lenses and focuses an image on an imaging element in the housing 1104. The focus of the lenses can be adjusted by adjusting their relative positions. This operation can also be automatically performed. The imaging apparatus may also be referred to as a photoelectric conversion apparatus. The photoelectric conversion apparatus can have, as an imaging method, a method of detecting a difference from a previous image or a method of cutting out a permanently recorded image, instead of taking an image one after another.

Fig. 4B is a schematic view of an example of electronic equipment according to the present embodiment. Electronic equipment 1200 includes a display unit 1201, an operating unit 1202, and a housing 1203. The housing 1203 may include a circuit, a printed circuit board including the circuit, a battery, and a communication unit. The operating unit 1202 may be a button or a touch panel response unit. The operating unit 1202 may be a biometric recognition unit that recognizes a fingerprint and releases the lock. Electronic equipment with a communication unit may also be referred to as communication equipment. The electronic equipment 1200 may have a lens and an imaging element and thereby further have a camera function. An image captured by the camera function is displayed on the display unit 1201. The electronic equipment 1200 may be a smartphone, a notebook computer, or the like.

Figs. 5A and 5B are schematic views of an example of the display apparatus according to the present embodiment. Fig. 5A illustrates a display apparatus, such as a television monitor or a PC monitor. A display apparatus 1300 includes a frame 1301 and a display unit 1302. The organic light-emitting element according to the present embodiment is used for the display unit 1302. The frame 1301 and the display unit 1302 are supported by a base 1303. The base 1303 is not limited to the structure illustrated in Fig. 5A. The lower side of the frame 1301 may also serve as the base. The frame 1301 and the display unit 1302 may be bent. The radius of curvature may be 5000 mm or more and 6000 mm or less.

Fig. 5B is a schematic view of another example of the display apparatus according to the present embodiment. A display apparatus 1310 in Fig. 5B is configured to be foldable and is a so-called foldable display apparatus. The display apparatus 1310 includes a first display unit 1311, a second display unit 1312, a housing 1313, and a folding point 1314. The first display unit 1311 and the second display unit 1312 include the organic light-emitting element according to the present embodiment. The first display unit 1311 and the second display unit 1312 may be a single display apparatus without a joint. The first display unit 1311 and the second display unit 1312 can be divided by the folding point. The first display unit 1311 and the second display unit 1312 may display different images or one image.

Fig. 6A is a schematic view of an example of a lighting apparatus according to the present embodiment. A lighting apparatus 1400 may include a housing 1401, a light source 1402, a circuit substrate 1403, an optical filter 1404 that transmits light emitted by the light source 1402, and a light-diffusing unit 1405. The light source 1402 includes the organic light-emitting element according to the present embodiment. The optical filter 1404 may be a filter that improves the color rendering properties of the light source. The light-diffusing unit 1405 can effectively diffuse light from the light source and widely spread light as in illumination. The optical filter 1404 and the light-diffusing unit 1405 may be provided on the light output side of the illumination. If necessary, a cover may be provided on the outermost side.

For example, the lighting apparatus is an interior lighting apparatus. The lighting apparatus may emit white light, neutral white light, or light of any color from blue to red. The lighting apparatus may have a light control circuit for controlling such light. The lighting apparatus may include the organic light-emitting element according to the present embodiment and a power supply circuit coupled to the organic light-emitting element. The power supply circuit is a circuit that converts an AC voltage to a DC voltage. White has a color temperature of 4200 K, and neutral white has a color temperature of 5000 K. The lighting apparatus may have a color filter.

The lighting apparatus according to the present embodiment may include a heat dissipation unit. The heat dissipation unit releases heat from the apparatus to the outside and may be a metal or liquid silicone with a high specific heat.

Fig. 6B is a schematic view of an automobile as an example of a moving body according to the present embodiment. The automobile has a taillight as an example of a lamp. An automobile 1500 may have a taillight 1501, which comes on when a brake operation or the like is performed.

The taillight 1501 includes the organic light-emitting element according to the present embodiment. The taillight

1501 may include a protective member for protecting the organic light-emitting element. The protective member may be formed of any transparent material with moderately high strength and can be formed of polycarbonate or the like. The polycarbonate may be mixed with a furan dicarboxylic acid derivative, an acrylonitrile derivative, or the like.

The automobile 1500 may have a body 1503 and a window 1502 on the body 1503. The window 1502 may be a transparent display as long as it is not a window for checking the front and rear of the automobile. The transparent display may include the organic light-emitting element according to the present embodiment. In such a case, constituent materials, such as electrodes, of the organic light-emitting element are transparent materials.

The moving body according to the present embodiment may be a ship, an aircraft, a drone, or the like. The moving body may include a body and a lamp provided on the body. The lamp may emit light to indicate the position of the body. The lamp includes the organic light-emitting element according to the present embodiment.

Application examples of the display apparatus according to one of the embodiments are described below with reference to Figs. 7A and 7B. The display apparatus can be applied to a system that can be worn as a wearable device, such as smart glasses, a head-mounted display (HMD), or smart contact lenses. An imaging and displaying apparatus used in such an application example includes an imaging apparatus that can photoelectrically convert visible light and a display apparatus that can emit visible light.

Fig. 7A is a schematic view of an example of a wearable device according to an embodiment of the present disclosure. Glasses 1600 (smart glasses) according to one application example are described below with reference to Fig. 7A. An imaging apparatus 1602, such as a complementary metal-oxide semiconductor (CMOS) sensor or a single-photon avalanche photodiode (SPAD), is provided on the front side of a lens 1601 of the glasses 1600. The display apparatus according to one of the embodiments is provided on the back side of the lens 1601.

The glasses 1600 further include a controller 1603. The controller 1603 functions as a power supply for supplying power to the imaging apparatus 1602 and the display apparatus. The controller 1603 controls the operation of the imaging apparatus 1602 and the display apparatus. The lens 1601 has an optical system for focusing light on the imaging apparatus 1602.

Fig. 7B is a schematic view of another example of a wearable device according to an embodiment of the present disclosure. Glasses 1610 (smart glasses) according to one application example are described below with reference to Fig. 7B. The glasses 1610 have a controller 1612, which includes an imaging apparatus corresponding to the imaging apparatus 1602 of Fig. 7A and a display apparatus. A lens 1611 includes an optical system for projecting light from the imaging apparatus of the controller 1612 and the display apparatus, and an image is projected on the lens 1611. The controller 1612 functions as a power supply for supplying power to the imaging apparatus and the display apparatus and controls the operation of the imaging apparatus and the display apparatus.

The controller 1612 may include a line-of-sight detection unit for detecting the line of sight of the wearer. Infrared radiation may be used to detect the line of sight. An infrared radiation unit emits infrared light to an eyeball of a user who is gazing at a display image. Reflected infrared light from the eyeball is detected by an imaging unit including a light-receiving element to capture an image of the eyeball. A reduction unit for reducing light from the infrared radiation unit to a display unit in a plan view is provided to reduce degradation in image quality. The line of sight of the user for the display image is detected from the image of the eyeball captured by infrared imaging. Any known technique can be applied to line-of-sight detection using the image of the eyeball. For example, it is possible to use a line-of-sight detection method based on a Purkinje image obtained by the reflection of irradiation light by the cornea. More specifically, a line-of-sight detection process based on a pupil-corneal reflection method is performed. The line of sight of the user is detected by calculating a line-of-sight vector representing the direction (rotation angle) of an eyeball on the basis of an image of a pupil and a Purkinje image included in a captured image of the eyeball using the pupil-corneal reflection method.

A display apparatus according to an embodiment of the present disclosure may include an imaging apparatus including a light-receiving element and may control a display image on the basis of line-of-sight information of a user from the imaging apparatus. More specifically, on the basis of the line-of-sight information, the display apparatus determines a first visibility region at which the user gazes and a second visibility region other than the first visibility region. The first visibility region and the second visibility region may be determined by the controller of the display apparatus or may be received from an external controller. In the display region of the display apparatus, the first visibility region may be controlled to have higher display resolution than the second visibility region. In other words, the second visibility region may have lower resolution than the first visibility region.

The display region has a first display region and a second display region different from the first display region, and the priority of the first display region and the second display region depends on the line-of-sight information. The first visibility region and the second visibility region may be determined by the controller of the display apparatus or may be received from an external controller. A region with a higher priority may be controlled to have higher resolution than another region. In other words, a region with a lower priority may have lower resolution.

The first visibility region or a region with a higher priority may be determined by artificial intelligence (AI). The AI may be a model configured to estimate the angle of the line of sight and the distance to a target ahead of the line of sight from an image of an eyeball using the image of the eyeball and the direction in which the eyeball actually viewed in the

image as teaching data. The AI program may be stored in the display apparatus, the imaging apparatus, or an external device. The AI program stored in an external device is transmitted to the display apparatus via communication.

For display control based on visual recognition detection, the present disclosure can be applied to smart glasses further having an imaging apparatus for imaging the outside. Smart glasses can display captured external information in real time.

Fig. 8A is a schematic view of an example of an image-forming apparatus according to an embodiment of the present disclosure. An image-forming apparatus 40 is an electrophotographic image-forming apparatus and includes a photosensitive member 27, an exposure light source 28, a charging unit 30, a developing unit 31, a transfer unit 32, a conveying roller 33, and a fixing unit 35. The exposure light source 28 emits light 29, and an electrostatic latent image is formed on the surface of the photosensitive member 27. The exposure light source 28 includes the organic light-emitting element according to the present embodiment. The developing unit 31 contains toner and the like. The charging unit 30 electrifies the photosensitive member 27. The transfer unit 32 transfers a developed image onto a recording medium 34. The conveying roller 33 conveys the recording medium 34. The recording medium 34 is paper, for example. The fixing unit 35 fixes an image on the recording medium 34.

Figs. 8B and 8C are schematic views of the exposure light source 28, wherein a plurality of light-emitting portions 36 are arranged on a long substrate. An arrow 37 indicates a direction parallel to the axis of the photosensitive member and indicates a column direction in which the light-emitting portions 36 including the organic light-emitting element are arranged. This column direction is the same as the direction of the rotation axis of the photosensitive member 27. This direction can also be referred to as the major-axis direction of the photosensitive member 27. In Fig. 8B, the light-emitting portions 36 are arranged in the major-axis direction of the photosensitive member 27. In Fig. 8C, unlike Fig. 8B, the light-emitting portions 36 are alternately arranged in the column direction in the first and second columns. The first and second columns are arranged at different positions in the row direction. In the first column, the light-emitting portions 36 are arranged at intervals. In the second column, the light-emitting portions 36 are arranged at positions corresponding to the spaces between the light-emitting portions 36 of the first column. Thus, the light-emitting portions 36 are also arranged at intervals in the row direction. The arrangement in Fig. 8C can also be referred to as a grid-like pattern, a staggered pattern, or a checkered pattern, for example.

As described above, an apparatus including the organic light-emitting element according to the present embodiment can be used to stably display a high-quality image for extended periods.

## EXAMPLES

The present disclosure is described below with exemplary embodiments. However, the present disclosure is not limited these exemplary embodiments.

### <Preparation of Composition>

9.988 g of a compound A-1 represented by the general formula [1] and 0.012 g of a compound A-2 represented by the general formula [2] were weighed with a microbalance. The weighed compounds were sufficiently mixed in a mortar, and the mixture was analyzed by high-performance liquid chromatography (HPLC). As a result, it was found that a composition 1-1 containing 0.12% by weight of the compound A-2 represented by the general formula [2] was prepared.

In the same manner as described above, as shown in Table 9, compositions 1-2 to 1-5 were prepared by changing the mixing ratio of A-2 to A-1. Furthermore, in the same manner as described above, compositions containing an assist represented by the general formula [2] at a different ratio was prepared by changing the mixing ratio of the assist represented by the general formula [2] to a host represented by the general formula [1] shown in Table 9.

Table 9

| Composition | First compound (host) | Second compound (assist) | Second compound content (weight%) |
|---|---|---|---|
| 1-0 | A1-1 | A1-2 | 0.00 |
| 1-1 | | | 0.12 |
| 1-2 | | | 0.06 |
| 1-3 | | | 0.01 |
| 1-4 | | | 0.18 |
| 1-5 | | | 0.24 |

(continued)

| Composition | First compound (host) | Second compound (assist) | Second compound content (weight%) |
|---|---|---|---|
| 2-0 | A3-1 | A3-2 | 0.00 |
| 2-1 | | | 0.14 |
| 2-2 | | | 0.22 |
| 3-0 | A5-1 | A5-2 | 0.00 |
| 3-1 | | | 0.11 |
| 3-2 | | | 0.25 |
| 4-0 | A7-1 | A7-2 | 0.00 |
| 4-1 | | | 0.09 |
| 4-2 | | | 0.21 |
| 5-0 | B1-1 | B1-2 | 0.00 |
| 5-1 | | | 0.15 |
| 5-2 | | | 0.25 |
| 6-0 | B3-1 | B3-2 | 0.00 |
| 6-1 | | | 0.13 |
| 6-2 | | | 0.22 |
| 7-0 | C1-1 | C1-2 | 0.00 |
| 7-1 | | | 0.14 |
| 7-2 | | | 0.24 |
| 8-0 | D2-1 | D2-2 | 0.00 |
| 8-1 | | | 0.12 |
| 9-0 | E1-1 | E1-2 | 0.00 |
| 9-1 | | | 0.06 |
| 10-0 | F1-1 | F1-2 | 0.00 |
| 10-1 | | | 0.18 |
| 11-0 | G1-1 | G1-2 | 0.00 |
| 11-1 | | | 0.15 |

(Exemplary Embodiment 1, Comparative Example 1)

An ITO film was formed on a glass substrate and was subjected to desired patterning to form an ITO electrode (positive electrode). The ITO electrode had a thickness of 100 nm. The substrate on which the ITO electrode was formed was used as an ITO substrate. Vacuum deposition was then performed by resistance heating in a vacuum chamber at 1.33 x $10^{-4}$ Pa (1 x $10^{-6}$ Torr) to continuously form an organic compound layer and an electrode layer shown in Table 10, thereby preparing an organic light-emitting element. The counter electrode (a metal electrode layer, a negative electrode) had an electrode area of 3 $mm^2$. The composition 1-1 in the light-emitting layer is a composition with the composition ratio shown in Table 9.

Table 10

| | Material | Film thickness (nm) |
|---|---|---|
| Negative electrode | Al | 100 |
| Electron-injection layer (EIL) | LiF | 1 |
| Electron-transport layer (ETL) | ET2 | 10 |

(continued)

| | Material | | | Film thickness (nm) |
|---|---|---|---|---|
| Hole-blocking layer (HBL) | ET12 | | | 20 |
| Light-emitting layer (EML) | Host + assist | Composition 1-1 | Weight ratio: composition 1-1:BD6 = 98:2 | 30 |
| | Guest | BD6 | | |
| Electron-blocking layer (EBL) | HT7 | | | 15 |
| Hole-transport layer (HTL) | HT3 | | | 30 |
| Hole-injection layer (HIL) | HT16 | | | 5 |

Characteristics of the organic light-emitting element were measured and evaluated, and blue light emission with a maximum current efficiency of 6.6 cd/A was obtained. More specifically, the current-voltage characteristics were measured with a microammeter 4140B manufactured by Hewlett-Packard Co., and the luminous brightness was measured with a BM7 manufactured by Topcon Corporation.

Organic light-emitting elements were prepared in the same manner as described above except that the composition 1-1 was changed to compositions 1-0 and 1-2 to 1-5 with different composition ratios shown in Table 9. The current efficiency of the organic light-emitting elements was measured in the same manner as described above. During continuous operation at a constant current density of 200 mA/cm$^2$, the time to half luminance was measured to evaluate the durability of the elements. The evaluation criteria were described below. Table 11 shows the results.

AAA: The time to half luminance is 1000 hours or more.

AA: The time to half luminance is 500 hours or more and less than 1000 hours.

A: The time to half luminance is 200 hours or more and less than 500 hours.

B: The time to half luminance is 50 hours or more and less than 200 hours.

C: The time to half luminance is less than 50 hours.

Table 11

| | Composition | Second organic compound (assist material) | | Current efficiency (cd/A) | Results of durability of element (LT50) @200mA/cm$^2$ |
|---|---|---|---|---|---|
| | | Structural formula | Content (%) | | |
| Exemplary embodiment 1 | 1-1 | A1-2 | 0.12 | 6.6 | AA |
| | 1-2 | | 0.06 | 6.8 | A |
| | 1-3 | | 0.01 | 6.8 | B |
| | 1-4 | | 0.18 | 6.5 | AA |
| Comparative example 1-1 | 1-5 | | 0.24 | 5.9 | AA |
| Comparative example 1-2 | 1-0 | - | 0.00 | 6.8 | C |

As shown in Table 11, when the second compound content is 0.2% by weight or less, the element lifetime is improved at almost constant current efficiency as compared with an element with a second compound content of 0% by weight. On the other hand, a second compound content of more than 0.2% by weight results in further improved durability lifetime but lower current efficiency.

(Exemplary Embodiments 2 to 10 and Comparative Examples 2 to 10)

Organic light-emitting elements were prepared in the same manner as in Exemplary Embodiment 1 except that the compositions of the first compound and the second compound and the light-emitting material were changed to the compositions and the light-emitting materials shown in Table 12. Characteristics of the elements were measured and evaluated in the same manner as in Exemplary Embodiment 1. Table 12 shows the measurement results. In Table 12, the second compound content is the second compound content of the composition (the first compound and the second

compound), and the light-emitting material content is the light-emitting material content of the light-emitting layer.

Table 12

| | Composition | Second organic compound (assist material) | | Light-emitting material (dopant material) | | Current efficiency (cd/A) | Results of durability of element (LT50) @200mA/cm$^2$ |
|---|---|---|---|---|---|---|---|
| | | Structural formula | Content (%) | Structural formula | Weight ratio (%) | | |
| Exemplary embodiment 2 | 1-1 | A1-2 | 0.12 | BD5 | 1.0 | 6.8 | AA |
| Comparative example 2-1 | 1-5 | | 0.24 | | | 6.0 | AA |
| Comparative example 2-2 | 1-0 | - | 0.00 | | | 7.0 | B |
| Exemplary embodiment 3 | 2-1 | A3-2 | 0.14 | BD7 | 1.5 | 6.4 | AA |
| Comparative example 3-1 | 2-2 | | 0.22 | | | 5.5 | AA |
| Comparative example 3-2 | 2-0 | - | 0.00 | | | 6.5 | C |
| Exemplary embodiment 4 | 3-1 | A5-2 | 0.11 | BD5 | 0.8 | 6.7 | AAA |
| Comparative example 4-1 | 3-2 | | 0.25 | | | 6.0 | AAA |
| Comparative example 4-2 | 3-0 | - | 0.00 | | | 6.9 | B |
| Exemplary embodiment 5 | 6-1 | B3-2 | 0.13 | BD6 | 2.5 | 6.5 | AA |
| Comparative example 5-1 | 6-2 | | 0.22 | | | 5.2 | AA |
| Comparative example 5-2 | 6-0 | - | 0.00 | | | 6.7 | C |
| Exemplary embodiment 6 | 7-1 | C1-2 | 0.14 | BD5 | 1.2 | 6.5 | AA |
| Comparative example 6-1 | 7-0 | - | 0.00 | | | 6.7 | C |
| Exemplary embodiment 7 | 8-1 | D2-2 | 0.12 | BD7 | 0.8 | 6.0 | A |
| Comparative example 7-1 | 8-0 | - | 0.00 | | | 6.2 | C |
| Exemplary embodiment 8 | 9-1 | E1-2 | 0.06 | GD5 | 1.0 | 6.8 | AA |
| Comparative example 8-1 | 9-0 | - | 0.00 | | | 7.0 | B |
| Exemplary embodiment 9 | 10-1 | F1-2 | 0.18 | BD6 | 2.0 | 6.3 | A |
| Comparative example 9-1 | 10-0 | - | 0.00 | | | 6.5 | C |

(continued)

| | Composition | Second organic compound (assist material) | | Light-emitting material (dopant material) | | Current efficiency (cd/A) | Results of durability of element (LT50) @200mA/cm$^2$ |
|---|---|---|---|---|---|---|---|
| | | Structural formula | Content (%) | Structural formula | Weight ratio (%) | | |
| Exemplary embodiment 10 | 11-1 | G1-2 | 0.15 | BD4 | 1.5 | 6.2 | AA |
| Comparative example 10-1 | 11-0 | - | 0.00 | | | 6.4 | B |

(Exemplary Embodiments 11 to 16 and Comparative Examples 11 to 16)

A 40-nm Ti film was formed on a glass substrate by a sputtering method and was patterned by photolithography to form a positive electrode. The counter electrode (a metal electrode layer, a negative electrode) had an electrode area of 3 mm$^2$. Subsequently, the substrate on which up to a cleaned electrode was formed and a material were mounted in a vacuum evaporator. After the vacuum evaporator was evacuated to 1.33 x $10^{-4}$ Pa (1 x $10^{-6}$ Torr), UV/ozone cleaning was performed. Subsequently, a film with a layer structure shown in Table 13 was formed and was finally sealed in a nitrogen atmosphere to prepare an organic light-emitting element according to Exemplary Embodiment 11.

Table 13

| | Material | | | Film thickness (nm) |
|---|---|---|---|---|
| Negative electrode | Mg | | Weight ratio Mg:Ag =50:50 | 10 |
| | Ag | | | |
| Electron-injection layer (EIL) | LiF | | | 1 |
| Electron-transport layer (ETL) | ET2 | | | 30 |
| Hole-blocking layer (HBL) | ET12 | | | 75 |
| Second light-emitting layer (2nd EML) | Second host (+assist) | Composition 5-1 | Weight ratio composition 5-1:BD7 =99.4:0.7 | 10 |
| | Second guest (blue dopant) | BD7 | | |
| First light-emitting layer (1st EML) | First host | B1-1 | Weight ratio B1-1:RD1:GD4 =97.2:0.3 :2.5 | 10 |
| | First guest (red dopant) | RD1 | | |
| | Third guest (green dopant) | GD4 | | |
| Electron-blocking layer (EBL) | HT8 | | | 10 |
| Hole-transport layer (HTL) | HT2 | | | 20 |
| Hole-injection layer (HIL) | HT16 | | | 5 |

The element emitted good white light. Organic light-emitting elements were prepared in the same manner as described above except that the structure of the organic compound layer was changed as shown in Table 14. The current efficiency of the organic light-emitting elements was measured in the same manner as described above. During continuous operation at a constant current density of 200 mA/cm$^2$, the time to half luminance was measured to evaluate the durability of the elements. The evaluation criteria were described below. Table 14 shows the results.

AAA: The time to half luminance is 2000 hours or more.
AA: The time to half luminance is 1500 hours or more and less than 2000 hours.
A: The time to half luminance is 1000 hours or more and less than 1500 hours.
B: The time to half luminance is 500 hours or more and less than 1000 hours.
C: The time to half luminance is less than 500 hours.

Table 14

| | 1st EML | | | 2nd EML | | | Results of durability of element (LT50) @200mA/cm$^2$ |
|---|---|---|---|---|---|---|---|
| | First host | First guest | Third guest | Second host | Assist | Second guest | |
| Exemplary embodiment 12 | B1-1 | RD1 | GD7 | Composition 5-1 | | BD7 | AAA |
| Comparative example 12 | | | | B1-1 | - | | B |
| Exemplary embodiment 13 | A5-1 | RD1 | GD6 | Composition 3-1 | | BD5 | AAA |
| Comparative example 13 | | | | A5-1 | - | | B |
| Exemplary embodiment 14 | B3-1 | RD1 | GD5 | Composition 6-1 | | BD7 | AA |
| Comparative example 14 | | | | B3-1 | - | | B |
| Exemplary embodiment 15 | EM1 | RD1 | GD5 | Composition 4-1 | | BD6 | A |
| Comparative example 15 | | | | A7-1 | - | | C |
| Exemplary embodiment 16 | EM26 | RD1 | GD8 | Composition 7-1 | | BD7 | AA |
| Comparative example 16 | | | | C1-1 | - | | B |
| Exemplary embodiment 17 | EM6 | RD1 | GD9 | Composition 11-1 | | BD5 | AA |
| Comparative example 17 | | | | G1-1 | - | | B |

The above evaluation shows that the second compound represented by the general formula [2] coexisting at a low concentration in the light-emitting layer with the first compound represented by the general formula [1] has an assist effect of trapping electric charges, reduces the collision probability between excitons and electric charges, and has an effect of improving the operation lifetime of the element.

The present disclosure can provide an organic light-emitting element with high light emission efficiency and good operation durability characteristics, and the organic light-emitting element can be used to provide equipment or an apparatus, such as a good light-emitting display apparatus.

While the present disclosure has been described with reference to exemplary embodiments, it is to be understood that the disclosure is not limited to the disclosed exemplary embodiments. The scope of the present disclosure is given by the appended claims.

## Claims

**1.** An organic light-emitting element (26) comprising:

a first electrode (2);
an organic compound layer (4, 22); and
a second electrode (5),
wherein the organic compound layer (4, 22) has a layer containing at least a first compound represented by the following general formula [1] and a second compound represented by the following general formula [2],

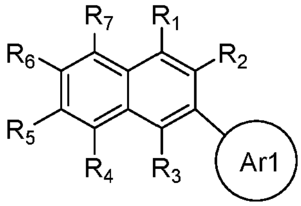 [1] 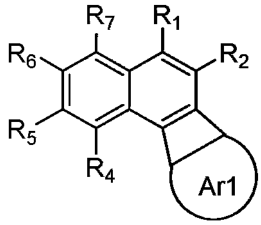 [2]

wherein $R_1$ to $R_7$ are each independently selected from the group consisting of a hydrogen atom, deuterium, a linear, branched, or cyclic substituted or unsubstituted alkyl group, a substituted or unsubstituted aryl group, and a substituted or unsubstituted heterocyclic group, and Ar1 denotes a substituted or unsubstituted tricyclic or higher cyclic fused group,
wherein the layer containing the first compound and the second compound is a light-emitting layer,
wherein the light-emitting layer contains a light-emitting material,
wherein the second compound has an oscillator strength, as calculated according to the description, of less than 0.1; **characterized in that** the first compound, the second compound, and the light-emitting material have LUMO energy levels $LUMO_1$, $LUMO_2$, and $LUMO_E$, respectively, satisfying the following formula [A]:

$$|LUMO_2| > |LUMO_E| > |LUMO_1| \qquad [A].$$

2. The organic light-emitting element (26) according to Claim 1, wherein a total weight of the first compound and the second compound contained in the light-emitting layer is 80% by weight or more and 99% by weight or less.

3. The organic light-emitting element (26) according to Claim 1 or 2, wherein a second compound content is more than 0 and less than 0.2% by weight with respect to 100% by weight of a total weight of the first compound and the second compound.

4. The organic light-emitting element (26) according to any one of Claims 1 to 3, wherein the first compound is a compound represented by the following general formula [3], and the second compound is a compound represented by the following general formula [4]:

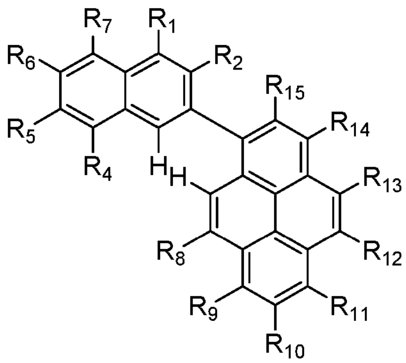 [3] 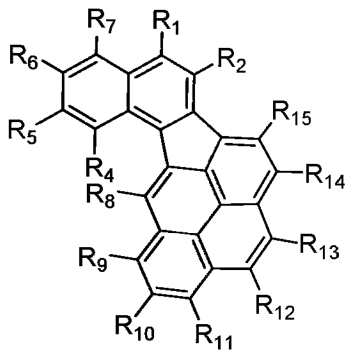 [4]

wherein $R_1$, $R_2$, and $R_4$ to $R_{15}$ are each independently selected from the group consisting of a hydrogen atom, a linear, branched, or cyclic alkyl group, a substituted or unsubstituted aryl group, and a substituted or unsubstituted heterocyclic group.

5. The organic light-emitting element (26) according to Claim 4, wherein in the first compound and the second compound, $R_5$ denotes a pyrenyl group, or $R_6$ denotes a fluorenyl group.

6. The organic light-emitting element (26) according to Claim 4, wherein $R_6$ in the first compound and the second compound denotes any one of a naphthyl group, a phenyl group, and a dibenzothiophenyl group.

7. The organic light-emitting element (26) according to any one of Claims 1 to 6, wherein Ar1 in the first compound and the second compound denotes a fused polycyclic group other than pyrene.

8. The organic light-emitting element (26) according to Claim 7, wherein Ar1 in the first compound and the second compound denotes a fluoranthene group.

9. The organic light-emitting element (26) according to Claim 7, wherein Ar1 in the first compound and the second compound denotes an anthracene group.

10. The organic light-emitting element (26) according to any one of Claims 1 to 9, further comprising:
a second light-emitting layer on the light-emitting layer, which is referred to as a first light-emitting layer, wherein the first light-emitting layer and the second light-emitting layer have different emission colors.

11. A display apparatus comprising a plurality of pixels, wherein at least one of the plurality of pixels includes the organic light-emitting element (26) according to any one of Claims 1 to 10 and a transistor (18) coupled to the organic light-emitting element.

12. A photoelectric conversion apparatus comprising:

an optical unit including a plurality of lenses;
an imaging element configured to receive light passing through the optical unit; and
a display unit (1201, 1302) configured to display an image taken by the imaging element,
wherein the display unit includes the organic light-emitting element (26) according to any one of Claims 1 to 10.

13. Electronic equipment comprising:

a display unit including the organic light-emitting element (26) according to any one of Claims 1 to 10;
a housing (1104, 1203, 1313, 1401) in which the display unit is provided; and
a communication unit provided in the housing and configured to communicate with an outside.

14. A lighting apparatus comprising:

a light source (1402) including the organic light-emitting element (26) according to any one of Claims 1 to 10; and
a light-diffusing unit (1405) or an optical filter (1404) configured to transmit light emitted by the light source.

15. A moving body comprising:

a lamp including the organic light-emitting element (26) according to any one of Claims 1 to 10; and
a body (1503) to which the lamp is provided.

16. An exposure light source (28) for an electrophotographic image-forming apparatus (40), comprising the organic light-emitting element (26) according to any one of Claims 1 to 10.

**Patentansprüche**

1. Organisches lichtemittierendes Element (26) umfassend:

eine erste Elektrode (2);
eine organische Verbindungsschicht (4, 22); und
eine zweite Elektrode (5),
wobei die organische Verbindungsschicht (4, 22) eine Schicht aufweist, die mindestens eine erste Verbindung, dargestellt durch die folgende allgemeine Formel [1], und eine zweite Verbindung, dargestellt durch die folgende allgemeine Formel [2], enthält,

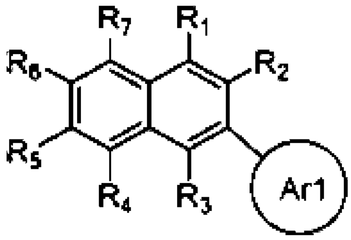 [1] 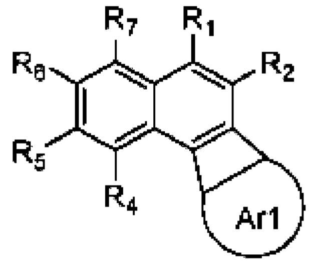 [2]

wobei $R_1$ bis $R_7$ jeweils unabhängig voneinander ausgewählt sind aus der Gruppe, bestehend aus einem Wasserstoffatom, Deuterium, einer linearen, verzweigten oder cyclischen substituierten oder unsubstituierten Alkylgruppe, einer substituierten oder unsubstituierten Arylgruppe und einer substituierten oder unsubstituierten heterocyclischen Gruppe, und Ar1 eine substituierte oder unsubstituierte tricyclische oder höherzyklische kondensierte Gruppe bezeichnet,
wobei die Schicht, die die erste Verbindung und die zweite Verbindung enthält eine lichtemittierende Schicht ist,
wobei die lichtemittierende Schicht ein lichtemittierendes Material enthält,
wobei die zweite Verbindung eine Oszillatorstärke, wie gemäß der Beschreibung berechnet, von weniger als 0,1 aufweist;

**dadurch gekennzeichnet, dass**
die erste Verbindung, die zweite Verbindung und das lichtemittierende Material jeweils LUMO-Energieniveaus $LUMO_1$, $LUMO_2$ bzw. $LUMO_E$ aufweisen, die die folgende Formel [A] erfüllen

$$|LUMO_2| > |LUMO_E| > |LUMO_1| \qquad [A]$$

2. Organisches lichtemittierendes Element (26) nach Anspruch 1, wobei ein Gesamtgewicht der ersten Verbindung und der zweiten Verbindung, die in der lichtemittierenden Schicht enthalten sind, 80 Gewichts-% oder mehr und 99 Gewichts-% oder weniger ist.

3. Organisches lichtemittierendes Element (26) nach Anspruch 1 oder 2, wobei ein Gehalt der zweiten Verbindung mehr als 0 und weniger als 0,2 Gewichts-% bezogen auf 100 Gewichts-% eines Gesamtgewichts der ersten Verbindung und der zweiten Verbindung ist.

4. Organisches lichtemittierendes Element (26) nach einem der Ansprüche 1 bis 3, wobei die erste Verbindung eine Verbindung ist, die durch die folgende allgemeine Formel [3] dargestellt wird, und die zweite Verbindung eine Verbindung ist, die durch die folgende allgemeine Formel [4] dargestellt wird:

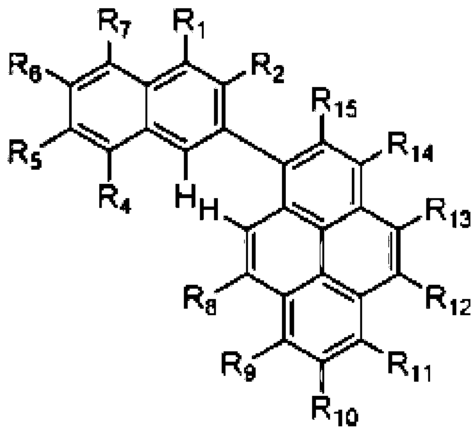 [3] 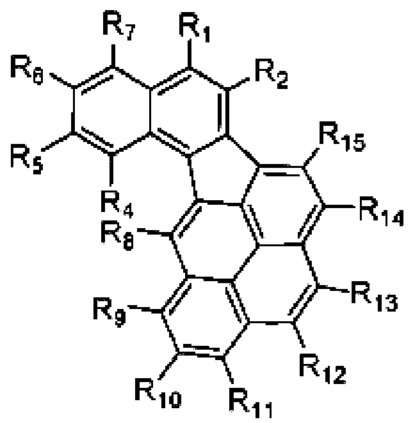 [4]

wobei $R_1$, $R_2$ und $R_4$ bis $R_{15}$ jeweils unabhängig voneinander ausgewählt sind aus der Gruppe, bestehend aus einem Wasserstoffatom, einer linearen, verzweigten oder cyclischen Alkylgruppe, einer substituierten oder unsubstituierten Arylgruppe und einer substituierten oder unsubstituierten heterocyclischen Gruppe.

5. Organisches lichtemittierendes Element (26) nach Anspruch 4, wobei in der ersten Verbindung und der zweiten

Verbindung $R_5$ eine Pyrenylgruppe bezeichnet oder $R_6$ eine Fluorenylgruppe bezeichnet.

**6.** Organisches lichtemittierendes Element (26) nach Anspruch 4, wobei $R_6$ in der ersten Verbindung und der zweiten Verbindung eine von einer Naphthylgruppe, einer Phenylgruppe und einer Dibenzothiophenylgruppe bezeichnet.

**7.** Organisches lichtemittierendes Element (26) nach einem der Ansprüche 1 bis 6, wobei Ar1 in der ersten Verbindung und der zweiten Verbindung eine kondensierte polyzyklische Gruppe außer Pyren bezeichnet.

**8.** Organisches lichtemittierendes Element (26) nach Anspruch 7, wobei Ar1 in der ersten Verbindung und der zweiten Verbindung eine Fluoranthengruppe bezeichnet

**9.** Organisches lichtemittierendes Element (26) nach Anspruch 7, wobei Ar1 in der ersten Verbindung und der zweiten Verbindung eine Anthracengruppe bezeichnet.

**10.** Organisches lichtemittierendes Element (26) nach einem der Ansprüche 1 bis 9, ferner umfassend:
eine zweite lichtemittierende Schicht auf der lichtemittierenden Schicht, welche als erste lichtemittierende Schicht bezeichnet wird, wobei die erste lichtemittierende Schicht und die zweite lichtemittierende Schicht unterschiedliche Emissionsfarben aufweisen.

**11.** Anzeigevorrichtung, die eine Vielzahl von Pixeln umfasst, wobei mindestens eines der Vielzahl von Pixeln das organische lichtemittierende Element (26) nach einem der Ansprüche 1 bis 10 und einen Transistor (18) beinhaltet, der an das organische lichtemittierende Element gekoppelt ist.

**12.** Fotoelektrische Umwandlungsvorrichtung, umfassend:

eine optische Einheit, die eine Vielzahl von Linsen beinhaltet;
einem Bildgebungselement, das konfiguriert ist, um Licht zu empfangen, das durch die optische Einheit hindurchgeht; und
einer Anzeigeeinheit (1201, 1302), die konfiguriert ist, um ein vom Bildgebungselement aufgenommenes Bild anzuzeigen,
wobei die Anzeigeeinheit das organische lichtemittierende Element (26) nach einem der Ansprüche 1 bis 10 beinhaltet.

**13.** Elektronische Ausrüstung, umfassend:

eine Anzeigeeinheit, die das organische lichtemittierende Element (26) nach einem der Ansprüche 1 bis 10 beinhaltet;
ein Gehäuse (1104, 1203, 1313, 1401), in dem die Anzeigeeinheit bereitgestellt ist; und
eine Kommunikationseinheit, die in dem Gehäuse bereitgestellt ist und konfiguriert ist, um mit einer Außenseite zu kommunizieren.

**14.** Beleuchtungsvorrichtung, umfassend:

eine Lichtquelle (1402), die das organische lichtemittierende Element (26) nach einem der Ansprüche 1 bis 10 beinhaltet; und
eine Lichtstreueinheit (1405) oder einen optischen Filter (1404), die/der konfiguriert ist, um Licht, das von der Lichtquelle emittiert wurde, zu übertragen.

**15.** Beweglicher Körper, umfassend:

eine Lampe, die das organische lichtemittierende Element (26) nach einem der Ansprüche 1 bis 10 beinhaltet; und
einen Körper (1503), an dem die Lampe bereitgestellt ist.

**16.** Belichtungslichtquelle (28) für ein elektrofotografisches Bilderzeugungsvorrichtung (40), die das organische lichtemittierende Element (26) nach einem der Ansprüche 1 bis 10 umfasst.

**Revendications**

1. Élément d'émission de lumière organique (26) comprenant :

une première électrode (2) ;
une couche de composés organiques (4, 22) ; et
une seconde électrode (5),
dans lequel la couche de composés organiques (4, 22) a une couche contenant au moins un premier composé représenté par la formule générale suivante [1] et un second composé représenté par la formule générale suivante [2],

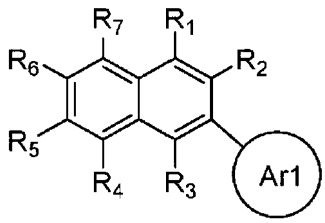
[1]
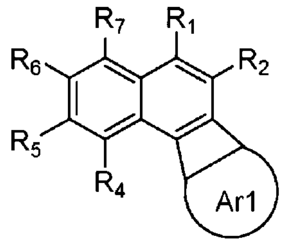
[2]

dans lequel $R_1$ à $R_7$ sont chacun sélectionnés indépendamment parmi le groupe consistant en un atome d'hydrogène, du deutérium, un groupe alkyle linéaire, ramifié, ou cyclique substitué ou non substitué, un groupe aryle substitué ou non substitué, et un groupe hétérocyclique substitué ou non substitué, et Ar1 désigne un groupe fusionné tricyclique ou cylique supérieur substitué ou non substitué,
dans lequel la couche contenant le premier composé et le second composé est une couche d'émission de lumière,
dans lequel la couche d'émission de lumière contient un matériau d'émission de lumière,
dans lequel le second composé présente une force d'oscillateur, telle que calculée selon la description, inférieure à 0,1 ; **caractérisé en ce que**
le premier composé, le second composé et le matériau d'émission de lumière ont des niveaux d'énergie LUMO $LUMO_1$,
$LUMO_2$ et $LUMO_E$, respectivement, satisfaisant à la formule suivante [A] :

$$|LUMO_2| > |LUMO_E| > |LUMO_1| \quad [A].$$

2. Élément d'émission de lumière organique (26) selon la revendication 1, dans lequel un poids total du premier composé et du second composé contenus dans la couche d'émission de lumière est de 80 % en poids ou plus et de 99 % en poids ou moins.

3. Élément d'émission de lumière organique (26) selon la revendication 1 ou 2, dans lequel une teneur en second composé est supérieure à 0 et inférieure à 0,2 % en poids par rapport à 100 % en poids d'un poids total du premier composé et du second composé.

4. Élément d'émission de lumière organique (26) selon l'une quelconque des revendications 1 à 3, dans lequel le premier composé est un composé représenté par la formule générale suivante [3], et le second composé est un composé représenté par la formule générale suivante [4] :

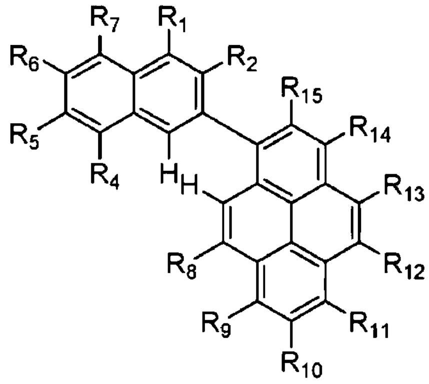 [3] 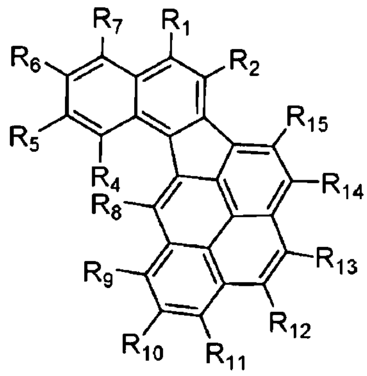 [4]

dans lequel $R_1$, $R_2$, et $R_4$ à $R_{15}$ sont sélectionnés chacun indépendamment dans le groupe consistant en un atome d'hydrogène. un groupe alkyle linéaire, ramifié ou cyclique, un groupe aryle substitué ou non substitué, et un groupe hétérocyclique substitué ou non substitué.

**5.** Élément d'émission de lumière organique (26) selon la revendication 4, dans lequel dans le premier composé et le second composé, $R_5$ désigne un groupe pyrenyle, ou $R_6$ désigne un groupe fluorenyle.

**6.** Élément d'émission de lumière organique (26) selon la revendication 4, dans lequel $R_6$ dans le premier composé et le second composé désigne l'un quelconque d'un groupe naphtyle, d'un groupe phényle et d'un groupe dibenzothiophényle.

**7.** Élément d'émission de lumière organique (26) selon l'une quelconque des revendications 1 à 6, dans lequel Ar1 dans le premier composé et le second composé désigne un groupe polycyclique fusionné autre que du pyrène.

**8.** Élément d'émission de lumière organique (26) selon la revendication 7, dans lequel Ar1 dans le premier composé et le second composé désigne un groupe fluoranthène.

**9.** Élément d'émission de lumière organique (26) selon la revendication 7, dans lequel Ar1 dans le premier composé et le second composé désigne un groupe anthracène.

**10.** Élément d'émission de lumière organique (26) selon l'une quelconque des revendications 1 à 9, comprenant en outre : une second couche d'émission de lumière sur la couche d'émission de lumière, qui est appelée une première couche d'émission de lumière, dans lequel la première couche d'émission de lumière et la second couche d'émission de lumière ont des couleurs d'émission différentes.

**11.** Appareil d'affichage comprenant une pluralité de pixels, dans lequel au moins l'un de la pluralité de pixels comporte l'élément d'émission de lumière organique (26) selon l'une quelconque des revendications 1 à 10 et un transistor (18) couplé à l'élément d'émission de lumière organique.

**12.** Appareil de conversion photoélectrique comprenant :

une unité optique comportant une pluralité de lentilles ; un élément d'imagerie configuré pour recevoir une lumière passant à travers l'unité optique ; et
une unité d'affichage (1201, 1302) configurée pour afficher une image prise par l'élément d'imagerie,
dans lequel l'unité d'affichage comporte l'élément d'émission de lumière organique (26) selon l'une quelconque des revendications 1 à 10.

**13.** Équipement électronique comprenant :

une partie d'affichage comportant l'élément d'émission de lumière organique (26) selon l'une quelconque des revendications 1 à 10 ;
un boîtier (1104, 1203, 1313, 1401) dans lequel l'unité d'affichage est agencée ; et
une unité de communication agencée dans le boîtier et configurée pour communiquer avec un extérieur.

**14.** Appareil d'éclairage comprenant :

une source de lumière (1402) comportant l'élément d'émission de lumière organique (26) selon l'une quelconque des revendications 1 à 10 ; et
une unité de diffusion de lumière (1405) ou un filtre optique (1404) configuré pour transmettre une lumière émise par la source de lumière.

**15.** Corps mobile comprenant :

une lampe comportant l'élément d'émission de lumière organique (26) selon l'une quelconque des revendications 1 à 10 ; et
un corps (1503) sur lequel la lampe est agencée.

**16.** Source de lumière d'exposition (28) pour un appareil de formation d'image électrophotographique (40), comprenant l'élément d'émission de lumière organique (26) selon l'une quelconque des revendications 1 à 10.

FIG. 1

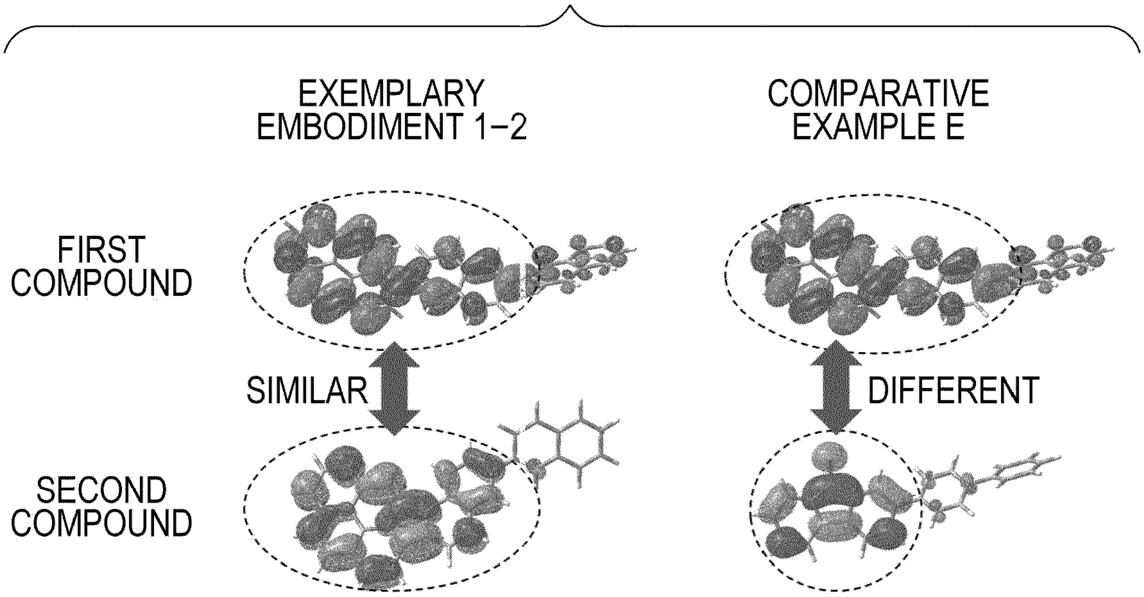
EXEMPLARY
EMBODIMENT 1-2
COMPARATIVE
EXAMPLE E
FIRST
COMPOUND
SIMILAR
DIFFERENT
SECOND
COMPOUND

FIG. 2A

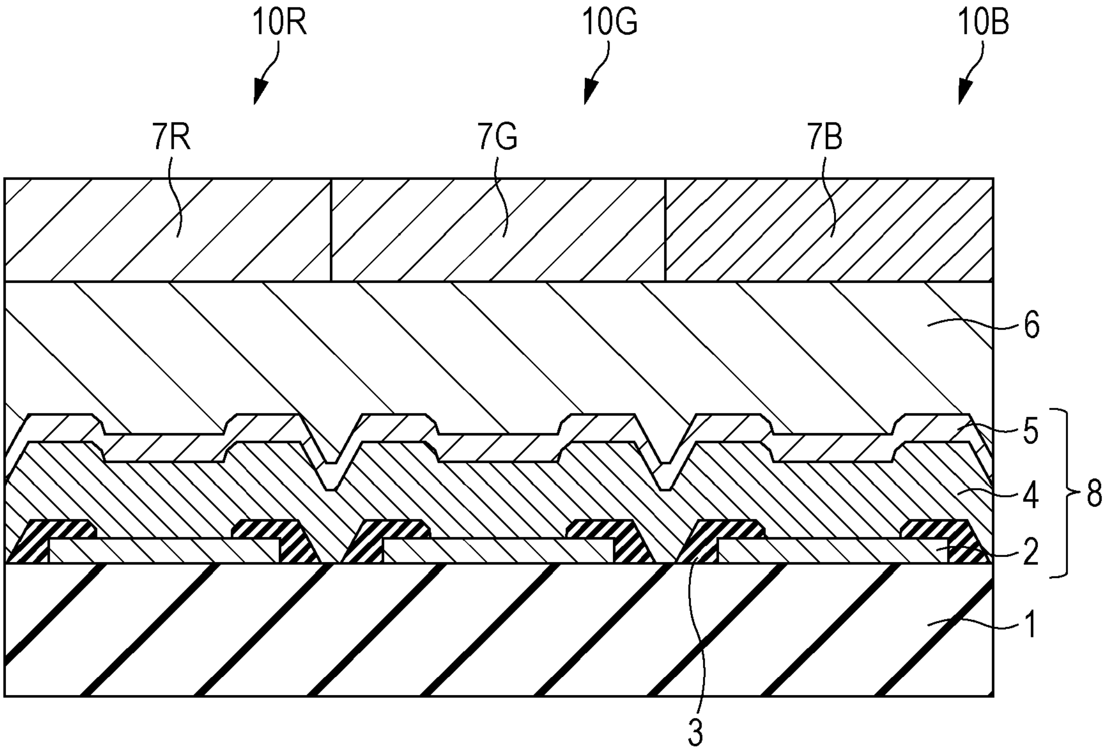
10R
10G
10B
7R
7G
7B
6
5
4
8
2
1
3

FIG. 2B

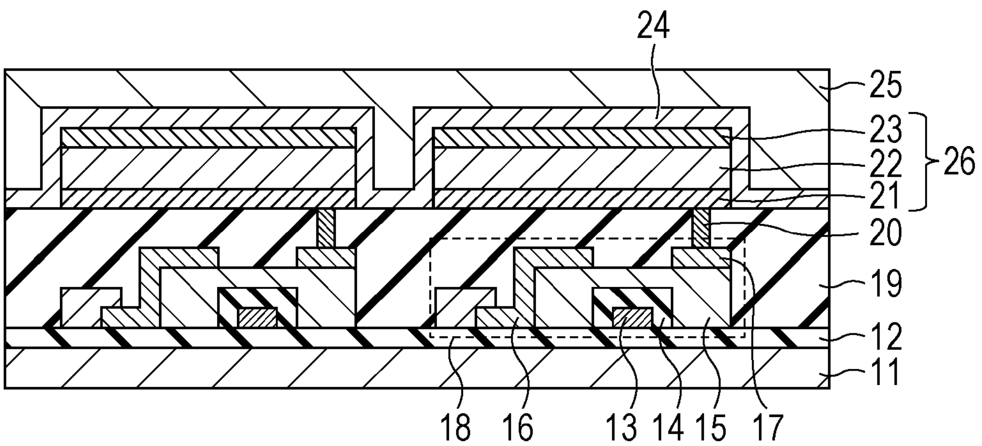
24
25
23
22
26
21
20
19
12
11
18
16
13
14
15
17

FIG. 3

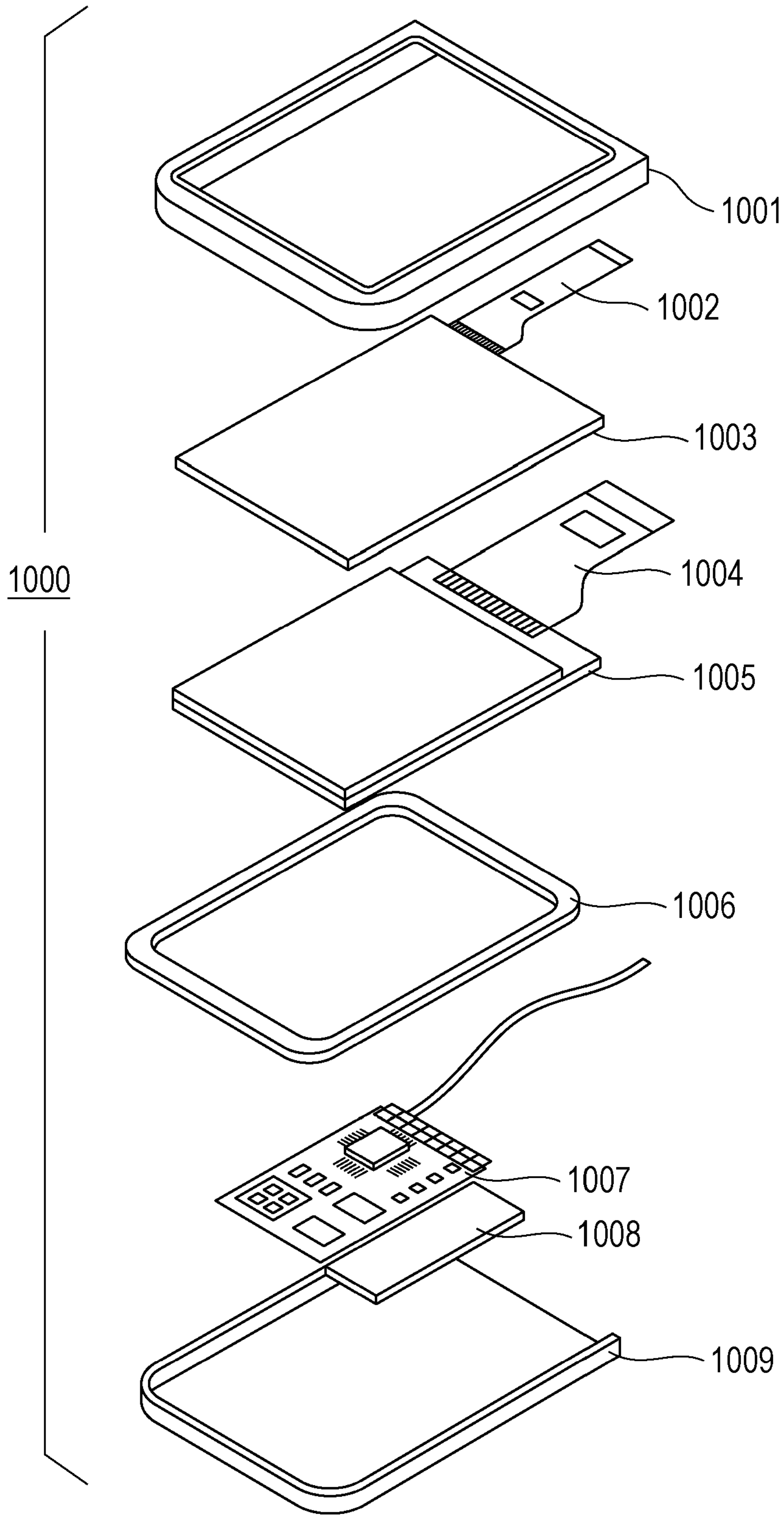

FIG. 4A

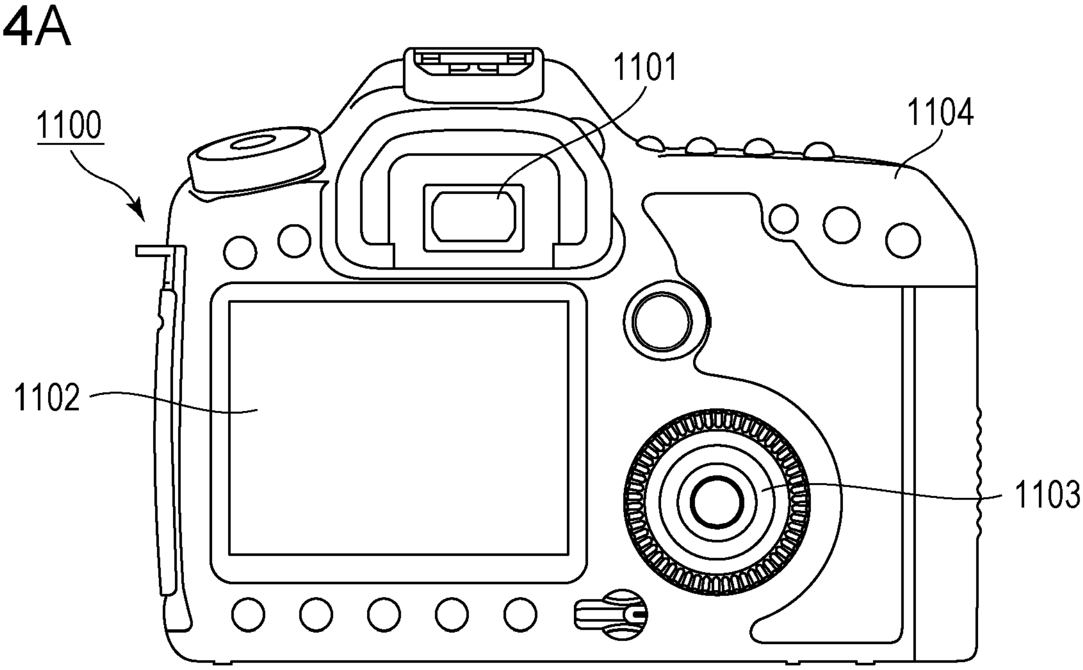


FIG. 4B

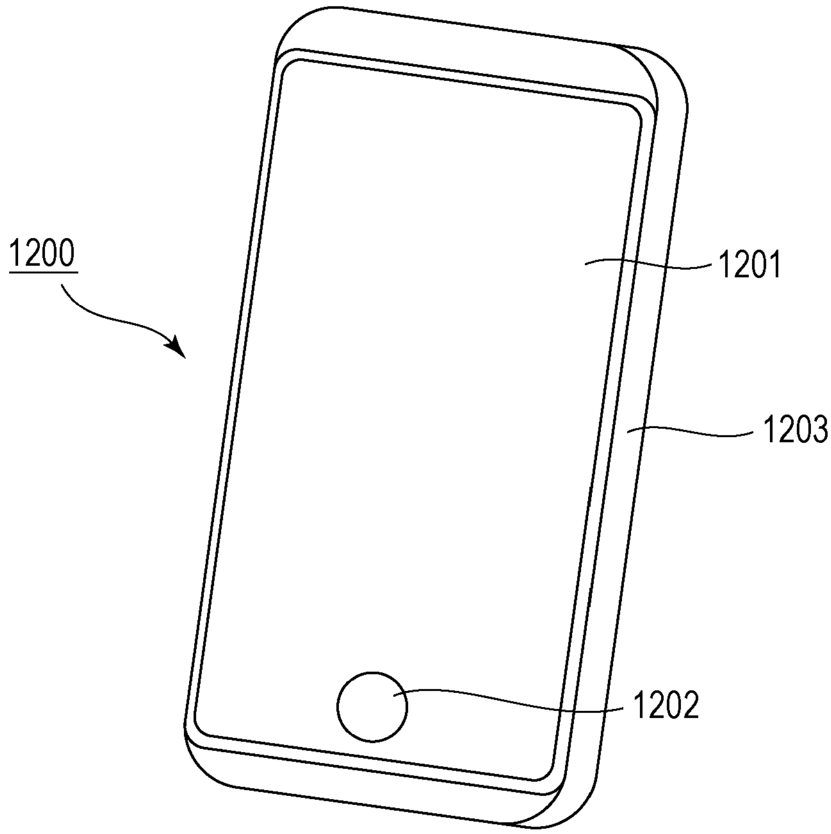

FIG. 5A

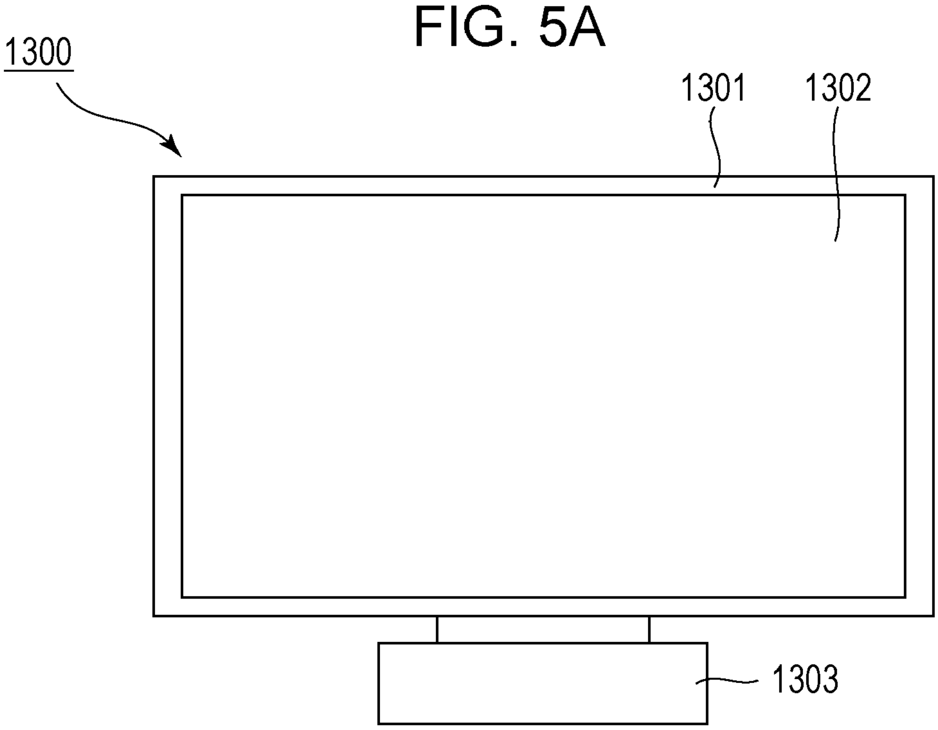


FIG. 5B

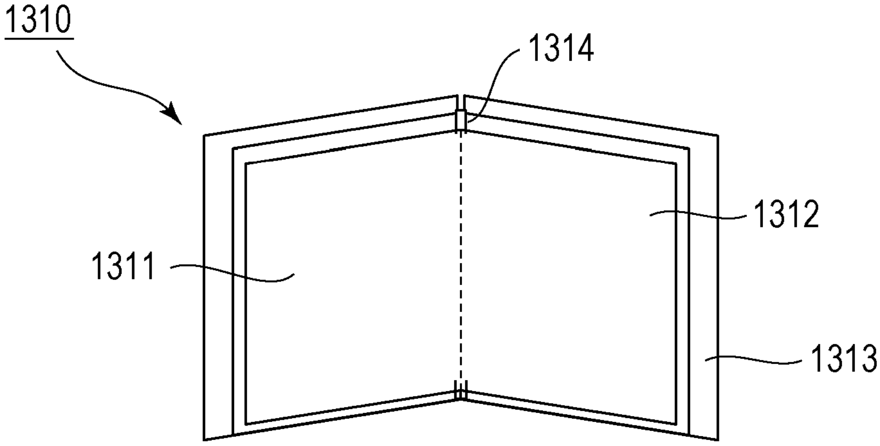

FIG. 6A

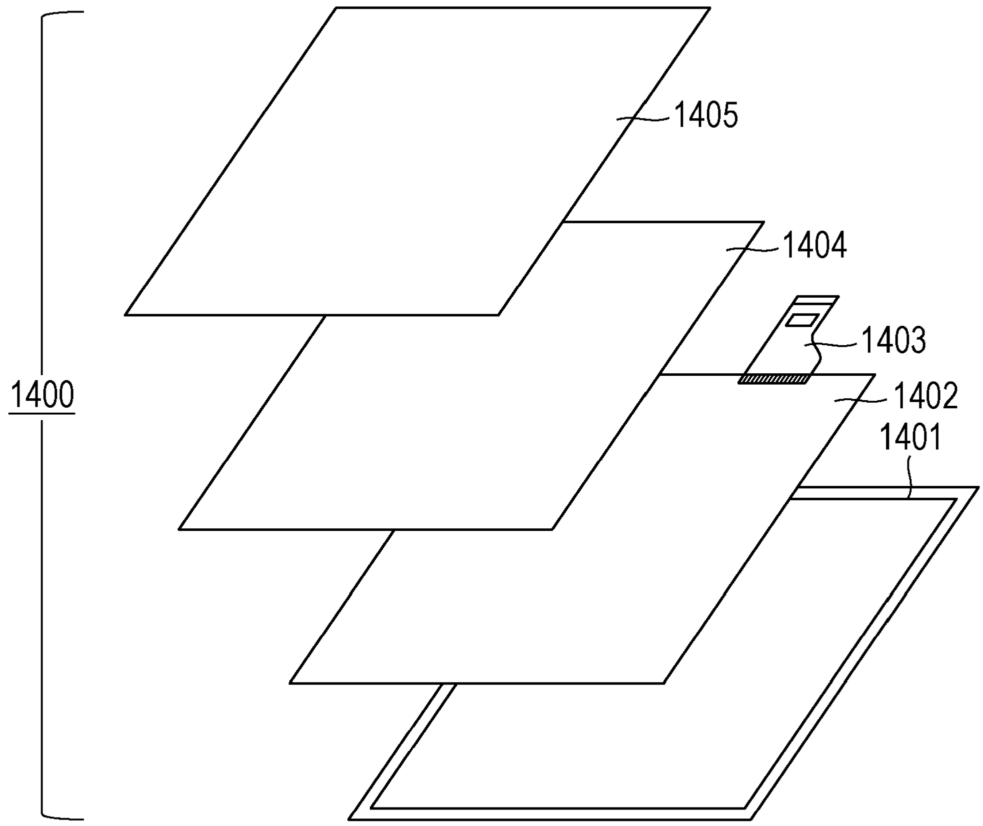


FIG. 6B

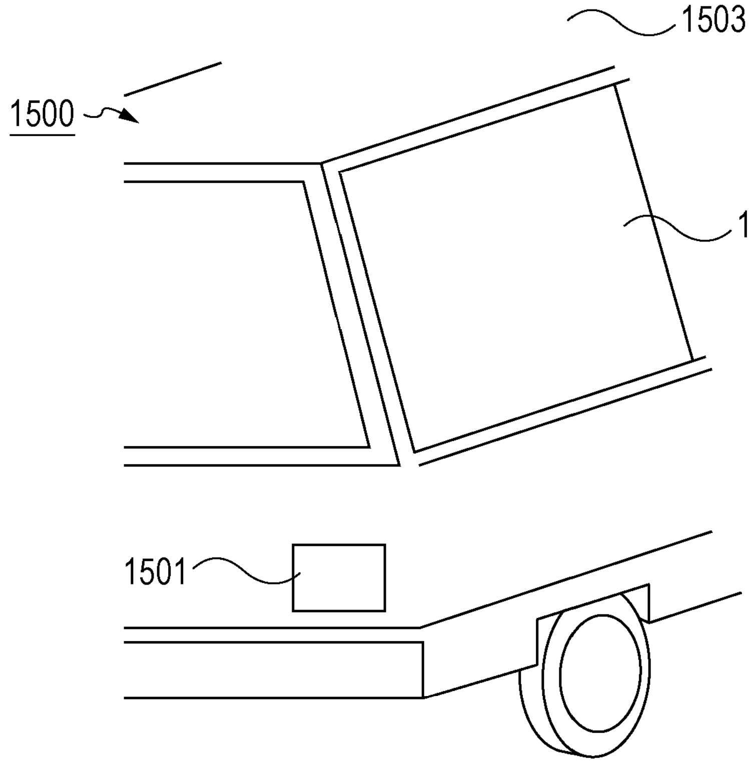

FIG. 7A

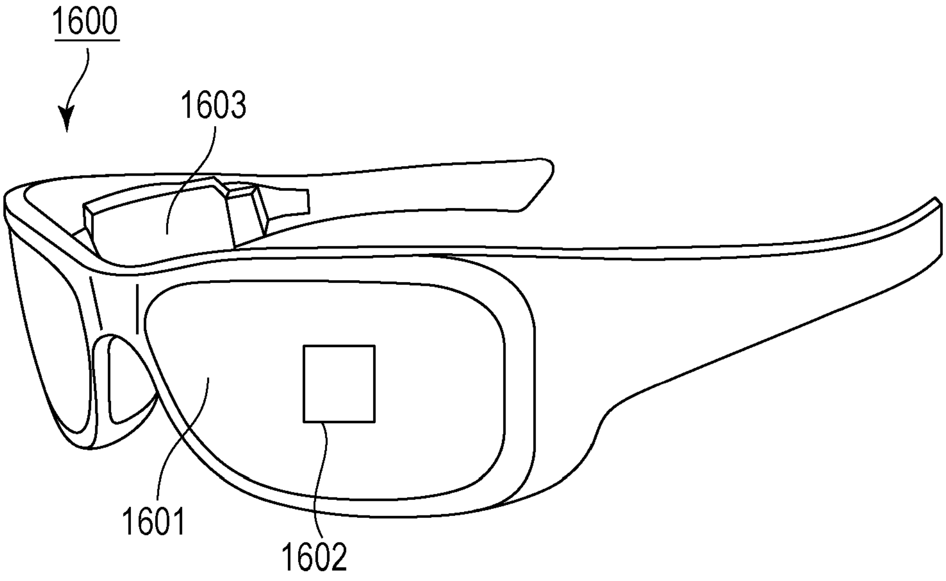


FIG. 7B

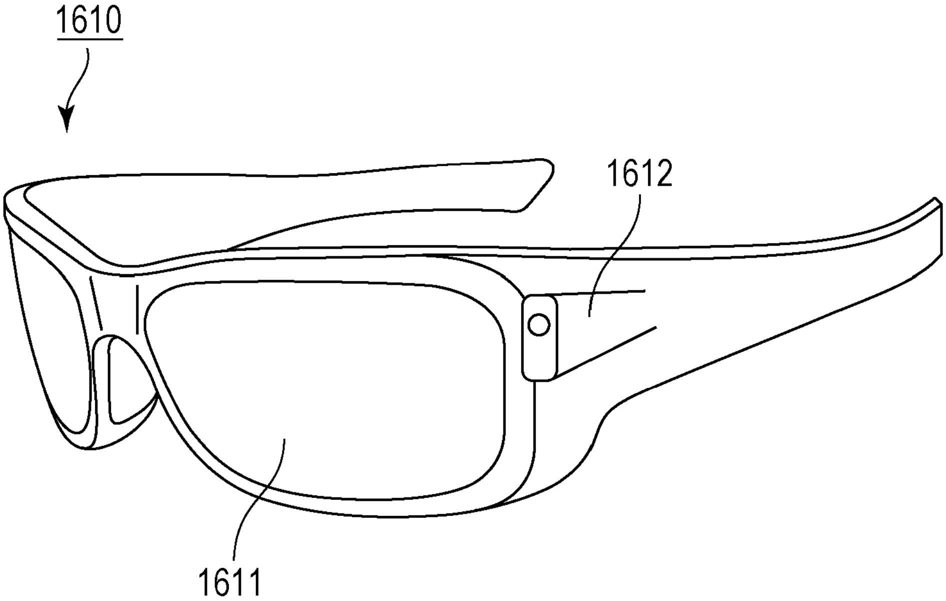

FIG. 8A

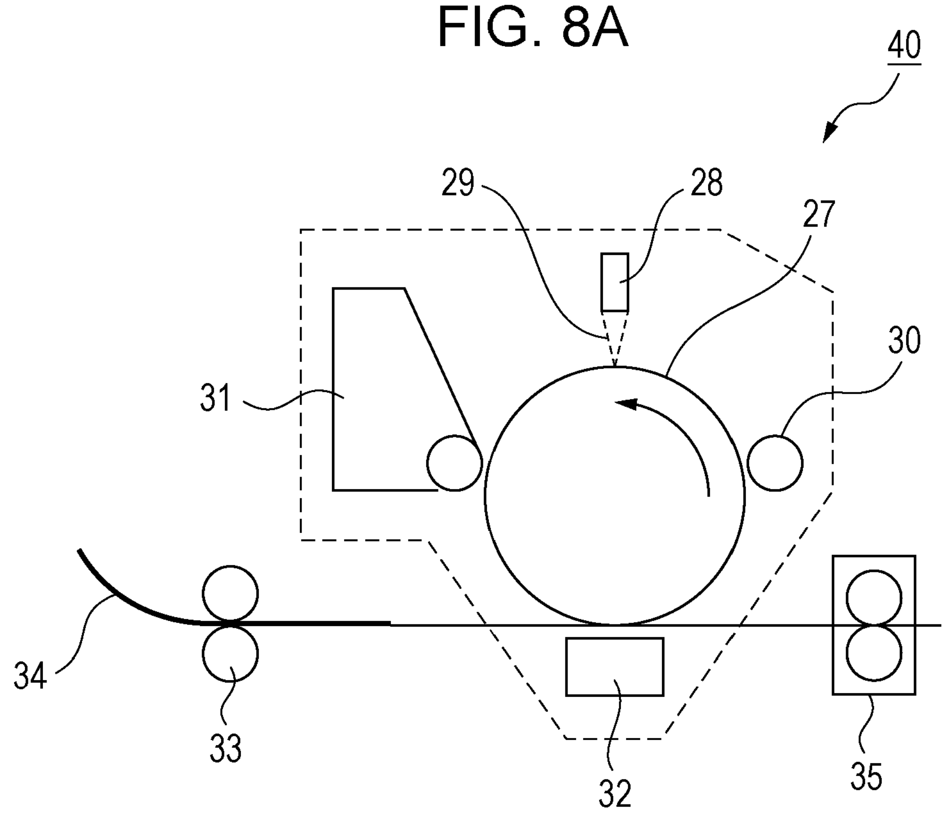


FIG. 8B

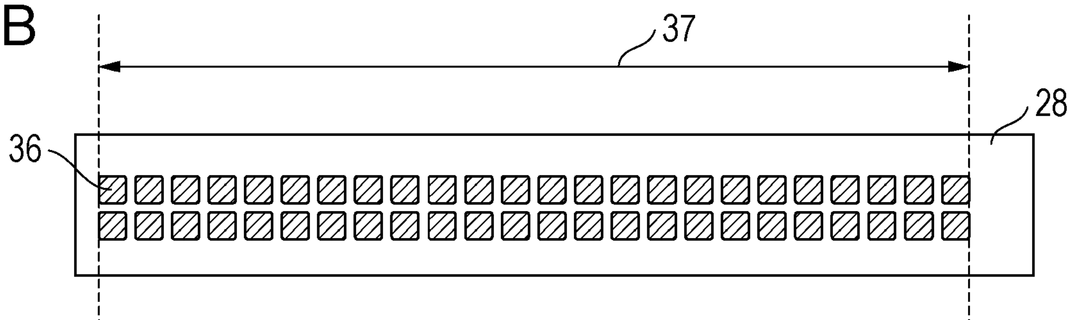


FIG. 8C

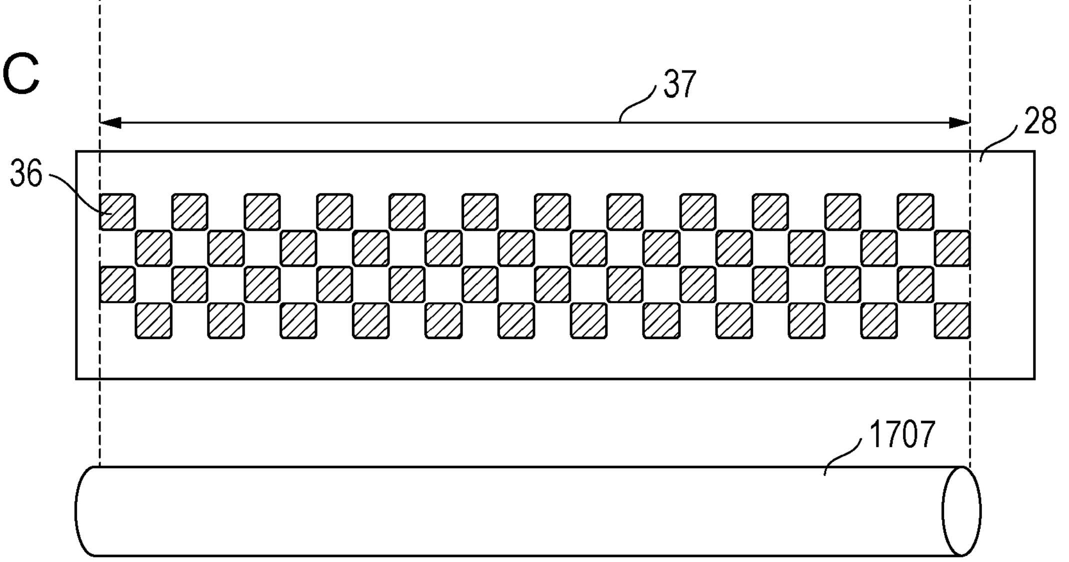

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2010123917 A
- KR 20140021969 A


### Non-patent literature cited in the description


- **M.J. FRISCH** ; **G.W. TRUCKS** ; **H.B. SCHLEGEL** ; **G.E. SCUSERIA** ; **M.A. ROBB** ; **J.R. CHEESEMAN** ; **G. SCALMANI** ; **V. BARONE** ; **B. MENNUCCI** ; **G.A. PETERSSON**. Gaussian. Gaussian, Inc., 2010, vol. 09